# EUROPEAN PATENT SPECIFICATION

(11) **EP 4 203 055 B1**
(45) Date of publication and mention of the grant of the patent: **10.06.2026**
(21) Application number: 21944572.3
(22) Date of filing: 10.06.2021
(51) Int. Cl.: H10K 59/38, H10K 59/122

(54) **SUBSTRATE COMPRISING WAVELENGTH CONVERSION UNIT AND MANUFACTURING METHOD THEREFOR, AND DISPLAY PANEL**
SUBSTRAT MIT WELLENLÄNGENUMWANDLUNGSEINHEIT UND HERSTELLUNGSVERFAHREN DAFÜR SOWIE ANZEIGETAFEL
SUBSTRAT COMPRENANT UNE UNITÉ DE CONVERSION DE LONGUEUR D'ONDE, SON PROCÉDÉ DE FABRICATION, ET PANNEAU D'AFFICHAGE

(43) Date of publication of application: 28.06.2023
(73) Proprietor: BOE Technology Group Co., Ltd., Beijing 100015 (CN)
(72) Inventor: ZHAO, Dejiang, Beijing 100176 (CN); HUANG, Wei, Beijing 100176 (CN); YUAN, Guangcai, Beijing 100176 (CN); WANG, Lu, Beijing 100176 (CN)
(74) Representative: AWA Sweden AB
(86) International application number: PCT/CN2021/099315
(87) International publication number: WO 2022/257062

(56) References cited:
- CN-A- 108 832 017
- CN-A- 109 830 614
- CN-A- 110 867 475
- CN-A- 111 341 804
- CN-A- 111 710 699
- CN-A- 112 270 895
- US-A1- 2013 027 765
- US-A1- 2020 257 162
- US-A1- 2021 183 957

## Description

### TECHNICAL FIELD

The present disclosure relates to a wavelength converting unit-containing substrate, a manufacture method therefor and a display panel.

### BACKGROUND

Organic light emitting display (OLED) as an mainstream display technology has occupied the market of mobile display, and also attracts significant interest of the manufactures in the display application such as TV. In view of the manner for displaying colors, the technical route of OLED is mainly divided into two types. One is to use organic light emitting materials which emit different colors respectively (such as red light emitting material, green light emitting material and blue light emitting material) to form sub-pixels for different colors, which is called the RGB type. The RGB type has a high color gamut, and has occupied the market of middle and small size applications. However, it cannot be scaled up to large area because it is limited by the fine metal mask (FMM) process. Although the RGB type where RGB OLEDs are printed by ink jet is a potential technology for large size OLED, the color gamut value is not high enough due to the limitation on the research and development of the OLED material obtained by a solution process. The other is to use a single color OLED as a backlight emitting unit in combination with color filters to achieve the color display, which is called the backlight-color filter type. The process in which a white backlight is combined with color filters has been one of the mainstream technologies for large size OLED because it may be achieved by deposition on the entire surface with an open mask. In the white backlight-color filter technology, the color filters function to filter light with wavelengths other than that for the desired color from the white light. The color gamut of the color filters directly limits the color gamut range of the large size OLED product.

A technology where a wavelength converting component is used to change the color of the light emitted by a single color OLED to achieve the color display has emerged. For example, a technology combining a blue OLED with quantum dots (QDs) has been proposed in related art, where the blue OLED is used as a light source to cooperate with the QDs to down-convert blue light into red light and green light, thereby achieving the color display. Such a technology is called the QD-OLED.

US2020/257162A1 discloses in Fig. 5E a wavelength converting unit-containing substrate comprising a partition wall WP consisting of a first layer WP1 and a second layer WP2. CN112270895A discloses in Figs. 1-2 a color filter substrate comprising a bank structure comprising a black matrix 211 and a baffle wall 222.

The development of the display panel comprising a wavelength converting component still faces many practical technical challenges. There is still a need for improving the display panel comprising a wavelength converting component, in particular a QD conversion layer.

### SUMMARY

In one aspect, the present disclosure provides a wavelength converting unit-containing substrate comprising:
a bank layer disposed on a base substrate, the bank layer comprising a plurality of bank segments, which are interconnected to enclose a plurality of sub-pixel regions, wherein adjacent sub-pixel regions are spaced apart by one of the plurality of bank segments,
the plurality of sub-pixel regions comprises sub-pixel regions for different colors, and each of the sub-pixel regions is filled with a wavelength converting unit for a corresponding color or filled with a transparent color filtering unit,
wherein for a bank segment between adjacent sub-pixel regions for different colors, an additional bank is provided at a side thereof away from the base substrate,
wherein for a bank segment between adjacent sub-pixel regions for the same color, no additional bank is provided at a side thereof away from the base substrate,
wherein for the bank segment between the adjacent sub-pixel regions for different colors, an auxiliary bank is further provided on the side thereof away from the base substrate, and is between the bank segment and the additional bank, wherein an orthographic projection of the auxiliary bank on the base substrate has a width less than that of an orthographic projection of the additional bank on the base substrate, and a maximum distance between the auxiliary bank and the base substrate is greater than a minimum distance between the additional bank and the base substrate,
wherein a plurality of sub-pixel regions for the same color are continuously arranged to form a group of sub-pixel regions, the auxiliary banks between the group of sub-pixel regions and sub-pixel regions adjacent thereto form a continuous auxiliary bank, and no auxiliary bank is provided within the group of sub-pixel regions, wherein the continuous auxiliary bank preferably forms two parallel banks at both flanks of the group of sub-pixel regions.

Optionally, the wavelength converting unit-containing substrate further comprises a protection layer, which is disposed at a side of the additional bank close to the base substrate and at a side of the auxiliary bank, the bank layer and the sub-pixel regions away from the base substrate.

Optionally, the auxiliary bank has a second cross section in a direction perpendicular to a primary surface of the base substrate, and when second transversal line segments in the second cross section are taken along a direction from being away from the base substrate to being close to the base substrate, there is a negative correlation between lengths of the second transversal line segments and distances from the second transversal line segments to the base substrate.

Optionally, the auxiliary bank has a height in a range of [2 µm, 5 µm].

Optionally, a ratio of a width of an orthographic projection of a bottom surface of the auxiliary bank on the base substrate to a width of an orthographic projection of a top surface of the bank segment between the auxiliary bank and the base substrate on the base substrate is in a range of [30%, 50%].

Optionally, the substrate further comprises a transparent layer, wherein the transparent layer is separated into transparent portions by the additional banks, and at least a part of the transparent portions have a convex lens morphology.

Optionally, a contact angle of an epoxy resin or an acrylic resin on a top surface of the additional bank is greater than or equal to 90°.

Optionally, a ratio of a width of an orthographic projection of a bottom surface of the additional bank on the base substrate to a width of an orthographic projection of a top surface of the bank segment between the additional bank and the base substrate on the base substrate is in a range of [0.8, 0.9].

Optionally, the additional bank comprises a black light-absorbing material, or a lateral surface of the additional bank comprises a light reflecting layer.

Optionally, the additional bank has a first cross section in a direction perpendicular to a primary surface of the base substrate, and when first transversal line segments in the first cross section are taken along a direction being away from the base substrate to being close to the base substrate, there is a negative correlation between lengths of the first transversal line segments and distances from the first transversal line segments to the base substrate.

Optionally, the base substrate comprises a color filter layer comprising a black matrix and color filters in spaces enclosed by the black matrix, wherein an orthographic projection of the bank segment on the base substrate is within an orthographic projection of the black matrix on the base substrate, and a ratio of a width of an orthographic projection of a bottom surface of the bank segment on the base substrate to a width of an orthographic projection of the black matrix on the base substrate is in a range of [0.8, 0.9].

Optionally, the different colors comprise red, green and blue, wherein a sub-pixel region for red is filled with a wavelength converting unit containing a red quantum dot material, a sub-pixel region for green is filled with a wavelength converting unit containing a green quantum dot material, and a sub-pixel region for blue is filled with a wavelength converting unit containing a blue quantum dot material or a transparent color filtering unit.

In another aspect, the present disclosure provides a display panel comprising:
an array substrate, wherein the array substrate comprises a pixel defining layer and light emitting units in spaces enclosed by the pixel defining layer, and
the wavelength converting unit-containing substrate according to any one of claims 1 to 17 aligned with the array substrate,
wherein the display panel comprises sub-pixels arranged in an array, wherein each of the sub-pixels comprises one light emitting unit in the array substrate and one wavelength converting unit or transparent color filtering unit in the wavelength converting unit-containing substrate, and the light emitting unit is disposed to be overlapped by the wavelength converting unit or transparent color filtering unit.

Optionally, the wavelength converting unit-containing substrate further comprises a transparent layer, which is separated into transparent portions by the additional banks, and a transparent filling portion is filled between the transparent portions and the array substrate, wherein the transparent filling portion has a refractive index less than that of the transparent portion.

Optionally, a plurality of supporters are further provided between the array substrate and the wavelength converting unit-containing substrate, and the supporters are in contact with at least a portion of the additional banks.

Optionally, the light emitting unit is an OLED light emitting unit.

In yet another aspect, the present disclosure provides a method for manufacturing the wavelength converting unit-containing substrate as described above, comprising steps of:
forming the bank layer and forming the auxiliary bank at a side of a portion of the bank segments in the bank layer away from the base substrate; and
after forming the auxiliary bank, forming the additional bank at a side of the auxiliary bank away from the base substrate.

Optionally, the step of forming the bank layer and forming the auxiliary bank comprises:
coating a photocurable material on the base substrate, and
forming the bank layer and forming the auxiliary bank integrally by exposure once with a halftone mask, such that an orthographic projection of a top surface of the auxiliary bank on the base substrate has a width less than that of an orthographic projection of a bottom surface of the auxiliary bank on the base substrate, and an orthographic projection of a top surface of the bank segment on the base substrate has a width greater than that of an orthographic projection of a bottom surface of the bank segment on the base substrate.

Optionally, a plurality of sub-pixel regions for the same color are continuously arranged to form a group of sub-pixel regions, the auxiliary banks between the group of sub-pixel regions and adjacent sub-pixel regions for a different color form a continuous auxiliary bank, the continuous auxiliary bank forms two parallel banks at both flanks of the group of sub-pixel regions, and no auxiliary bank is provided within the group of sub-pixel regions, and
the method comprises coating a material for the wavelength converting unit or the transparent color filtering unit in the group of sub-pixel regions between the two parallel banks by slit coating.

### BRIEF DESCRIPTION OF DRAWINGS

Figs. 1(a) and 1(b) show a schematic structure of an embodiment of a display panel having a wavelength converting unit in related art.
Figs. 2(a) and 2(b) show a partial schematic diagram of the pixel arrangement of an embodiment of a wavelength converting unit-containing substrate.
Figs. 3(a)-3(d) show some other possible sub-pixel arrangements.
Fig. 4 shows a sectional view taken along line A-A' in Fig. 2.
Fig. 5 shows a sectional view taken along line B-B' in Fig. 2.
Figs. 6(a) and 6(b) schematically show the situations where a transparent portion in a wavelength converting unit-containing substrate forms a convex lens morphology.
Fig. 7 schematically shows an embodiment of a wavelength converting unit-containing substrate comprising a color filter layer.
Fig. 8 schematically shows an embodiment of a wavelength converting unit-containing substrate comprising a protection layer.
Fig. 9 schematically shows an embodiment of a wavelength converting unit-containing substrate comprising an auxiliary bank.
Fig. 10 schematically shows an embodiment comprising both a protection layer and an auxiliary bank.
Fig. 11 schematically shows a normal trapezoid auxiliary bank.
Fig. 12 schematically shows a combination of an inverse trapezoid bank and a normal trapezoid auxiliary bank.
Figs. 13(a)-13(e) schematically show a process for forming an embodiment of a wavelength converting unit-containing substrate.
Fig. 14 shows an embodiment of an array substrate.
Fig. 15 schematically shows a structure of a display panel manufactured according to an embodiment.
Fig. 16 shows an embodiment of a wavelength converting unit-containing substrate of the present disclosure.
Fig. 17 schematically shows a structure of an embodiment of a display panel.
Fig. 18 schematically shows a structure of an embodiment of a display panel.
Fig. 19 shows another embodiment of a wavelength converting unit-containing substrate of the present disclosure.

### Detailed Description

In a color filter layer having a wavelength converting unit, there is always a gap between the backlight source and the wavelength converting unit. In most cases, the gap will be greater than 10 µm. When the gap is relatively large, although the black matrix, the bank layer, the optical adjustment layer or the like provide the function of blocking light, it is still very difficult to avoid the cross color of light between different pixels. In order to avoid the light leakage between adjacent sub-pixels for different colors and the cross color caused by the light leakage, in the present disclosure, an additional bank is additionally provided on the bank layer between the wavelength converting units.

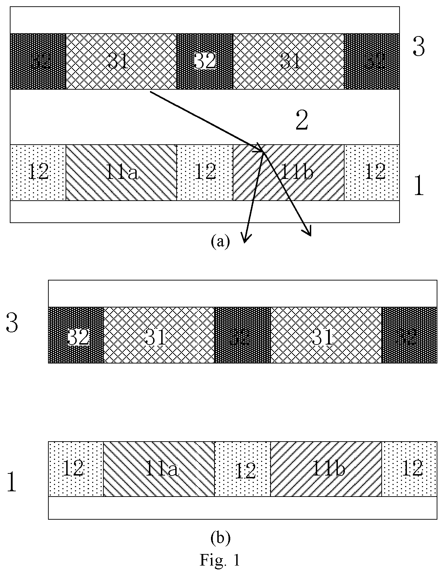

Figs. 1(a) and 1(b) show a schematic structure of an embodiment of a display panel having a wavelength converting unit in related art. Two adjacent pixels are shown in the figure. The display panel may comprise a light emitting portion 3, a transparent spacing portion 2, a wavelength converting portion 1, and base plates on both sides. The light emitting portion comprises a pixel defining layer 32 which defines the light emitting units of the sub-pixels. Two light emitting units 31 are shown in the figure. The light emitting units 31 emit light with the same color. The wavelength converting portion 1 comprises a bank layer 12 which defines the wavelength converting units (or the transparent color filtering units) 11a, 11b and so on of the sub-pixels. The wavelength converting units for different colors cause lights emitted by corresponding light emitting units to change color, and the transparent color filtering units do not cause lights emitted by corresponding light emitting units to change color. As such, a color display is achieved by using an array of light emitting units 31 of the same color. A color filter portion may further be provided on a light-exiting side of the wavelength converting portion, and functions to filer light for filtering out unconverted backlight or any other possible undesired light.

The light emitting unit may be an OLED light emitting unit or the like. The wavelength converting unit is formed from a wavelength converting material, and may emit light by photoluminescence.

A transparent spacing layer 2 is provided between the light emitting portion and the wavelength converting portion. It is used to space apart the light emitting portion and the wavelength converting portion, and may also have functions of supporting, encapsulation and protection.

As shown in Fig. 1(a), because the transparent spacing layer is present, the light emitted from the light emitting unit of the sub-pixel may travel in the transparent spacing layer and arrive at the wavelength converting unit of the adjacent sub-pixel, thereby causing the adjacent sub-pixel to emit light. If the adjacent sub-pixel should not emit light at this time, the phenomena of cross color will occur. The arrows in the figure indicate that the light emitted by the light emitting unit 31 may cause photoluminescence in the adjacent wavelength converting unit 11b, thereby resulting in cross color.

Typically, the structure in Fig. 1(a) is prepared by a cell alignment process. In the cell alignment process, the light emitting portion 3 and the wavelength converting portion 1 as shown in Fig. 1(b) are respectively prepared, wherein the light emitting portion may be separately made into an array substrate, and the wavelength converting portion may be separately made into a wavelength converting unit-containing substrate. Then, the light emitting portion and the wavelength converting portion are assembled together opposite to each other, such that the light emitting unit is aligned with the wavelength converting unit in each sub-pixel, and a transparent filler may be filled between the light emitting portion and the wavelength converting portion, thereby forming a display panel.

In an embodiment, the present disclosure provides a wavelength converting unit-containing substrate comprising:
a bank layer disposed on a base substrate, the bank layer comprising a plurality of bank segments, which are interconnected to enclose a plurality of sub-pixel regions, wherein adjacent sub-pixel regions are spaced apart by one of the plurality of bank segments,
the plurality of sub-pixel regions comprises sub-pixel regions for different colors, and each of the sub-pixel regions is filled with a wavelength converting unit for a corresponding color or filled with a transparent color filtering unit,
wherein for a bank segment between adjacent sub-pixel regions for different colors, an additional bank is provided at a side thereof away from the base substrate.

The wavelength converting unit-containing substrate of the present disclosure comprises a bank layer disposed on a base substrate. The base substrate refers to a substrate serving as a basis for the bank layer. In the field of display, typically, a filter for filtering a backlight with mixed color (for example, a white backlight) to obtain a light with a single color is referred to as a color filter, and a color filter-containing substrate to be aligned and assembled with a white backlight substrate is referred to as a color filter substrate. In a wavelength converting-type display device, although the change in color of a light is achieved through wavelength conversion caused by photoluminescence, the name "color filter substrate" is usually still used, and for example, a QD wavelength converting unit is sometimes referred to as "a QD color filter" as well. The wavelength converting unit-containing substrate of the present disclosure may also be referred to as a color filter substrate. Furthermore, the wavelength converting unit-containing substrate may also comprise a real color filter for filtering light.

The bank layer is composed of a plurality of bank segments for separating the sub-pixel regions. In particular, the bank layer comprising a plurality of bank segments, which are interconnected to enclose a plurality of sub-pixel regions, wherein adjacent sub-pixel regions are spaced apart by one of the plurality of bank segments. Here, the expression "interconnected" means that the ends thereof are connected to each other. The ends of a plurality of bank segments with substantially the same height are connected with each other, enclosing regions for forming sub-pixels. Each bank segment extends along the common boundary between adjacent sub-pixel regions separated thereby, and the two ends of the common boundary serve as the ends of the bank segment. In the present disclosure, for any bank segment, a direction perpendicular to the base substrate is its height direction, a direction parallel to the base substrate and extending along the above common boundary is its length direction, and a direction parallel to the base substrate and perpendicular to its length direction is its width direction. That is, its width direction is a direction of the distance between the two adjacent sub-pixel regions. The description of the above length, width and height directions is also suitable for the additional bank, the auxiliary bank and the black matrix as described below.

Typically, the bank segments have substantially the same height, such that a wavelength converting material or a transparent color filtering material is filled in the same depth. In an embodiment, the bank layer is formed by patterning with a photolithography process. For example, a layer of photocurable material is applied, then exposed and developed with a mask, and patterned by removing the material not cured under light, so as to obtain a bank layer composed of a plurality of bank segments with the same heights.

In some embodiments, between the separated sub-pixel regions, the bank segment may have a section in the height and width plane, which is substantially constant along its length direction.

For conventional rectangular sub-pixel regions, each sub-pixel region may be enclosed by the first direction bank segments and the second direction bank segments, wherein the first direction is perpendicular to the second direction. For other special shaped sub-pixel regions, the direction of the bank segments enclosing each sub-pixel depends on the position of its adjacent sub-pixel region.

The plurality of sub-pixel regions comprises sub-pixel regions for different colors. Each of the sub-pixel regions is filled with a wavelength converting unit for a corresponding color or filled with a transparent color filtering unit. The present disclosure relates to a wavelength converting unit-containing substrate. Therefore, at least some of the sub-pixel regions are filled with a wavelength converting unit. Because the wavelength converting unit is photoluminescent, the problem of cross color caused by the light leakage between the sub-pixels is relatively serious for the wavelength converting unit.

The wavelength converting unit-containing substrate may comprise wavelength converting units for various colors.

For example, a portion of sub-pixel regions may be red sub-pixel regions and filled with a red wavelength converting unit, another portion thereof may be green sub-pixel regions and filled with a green wavelength converting unit, and the remaining portion thereof may be blue sub-pixel regions and filled with a blue wavelength converting unit. If the backlight is blue light, the blue sub-pixel regions may also be filled with a transparent color filtering unit.

The wavelength converting unit is used for converting a wavelength emitted by the light emitting unit of the sub-pixel to a desired color. For example, a red wavelength converting unit may convert a blue backlight to a red light, and a green wavelength converting unit may convert a blue backlight to a green light. An example of the wavelength converting unit may be a quantum dot (QD) material portion, an inorganic phosphor powder material portion, or an organic phosphor powder material portion, and may comprise a transparent matrix material and quantum dots, inorganic phosphor powders or organic phosphor powders dispersed in the matrix material. The wavelength converting unit may also be made from other wavelength converting materials. The matrix material may be a transparent organic material, such as resin, for example, cured photoresist resin, or cured ink. Any suitable down-conversion material may be used as the down-conversion material, which is not particularly limited in the present disclosure. Here, the QD down-conversion material is particularly preferred because its down-conversion performance may be controlled through the particle size.

In an embodiment, the wavelength converting unit may comprise a base resin and quantum dots mixed with the base resin (or dispersed in the base resin). The base resin may be a medium in which the quantum dots are dispersed. The base resin may be formed from at least one of various resin composite materials which are generally referred to as an adhesive. However, the inventive concept of the present disclosure is not limited thereto. For example, a medium capable of dispersing quantum dots may be used as the base resin, regardless of its name, additional functions and/or constituent materials. In some exemplary embodiments, the base resin may be a polymer resin. For example, the base resin may be an acrylic resin, an ethyl carbamate-based resin, a silicon-based resin, or an epoxy resin. The base resin may be a transparent resin.

The quantum dot may be a particle configured to convert the wavelength of an incident light. Each quantum dot may be a material having a crystal structure with a size of several nanometers, and may be composed of hundreds to thousands of atoms. The quantum dot may exhibit a quantum confinement effect, where the energy band gap is increased due to small size. When a light with a wavelength corresponding to an energy greater than the energy band gap is incident onto the quantum dot, the quantum dot may be excited by absorbing the light, and then turn to a ground state and emit a light with a particular wavelength at the same time. The emitted light may have an energy corresponding to the energy band gap. The light emitting property of the quantum dot due to the quantum confinement effect may be controlled by adjusting the size and/or composition of the quantum dot.

The quantum dot may be formed from a Group II-VI compound, a Group III-V compound, a Group IV-VI compound, a Group IV element, a Group IV compound, or any combination thereof.

The Group II-VI compound may be selected from the group consisting of: a binary compound selected from the group consisting of CdSe, CdTe, ZnS, ZnSe, ZnTe, ZnO, HgS, HgSe, HgTe, MgSe, MgS and any mixture thereof; a ternary compound selected from the group consisting of AgInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS and any mixture thereof; and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe and any mixture thereof.

The Group III-V compound may be selected from the group consisting of: a binary compound selected from the group consisting of GaN, GaP, GaAs, GaSb, AlN, AlP, AlAs, AlSb, InN, InP, InAs, InSb and any mixture thereof; a ternary compound selected from the group consisting of GaNP, GaNAs, GaNSb, GaPAs, GaPSb, AlNP, AlNAs, AlNSb, AlPAs, AlPSb, InNP, InNAs, InNSb, InPAs, InPSb and any mixture thereof; and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb and any mixture thereof. The Group IV-VI compound may be selected from the group consisting of: a binary compound selected from the group consisting of SnS, SnSe, SnTe, PbS, PbSe, PbTe and any mixture thereof; a ternary compound selected from the group consisting of SnSeS, SnSeTe, SnSTe, PbSeS, PbSeTe, PbSTe, SnPbS, SnPbSe, SnPbTe and any mixture thereof; and a quaternary compound selected from the group consisting of SnPbSSe, SnPbSeTe, SnPbSTe and any mixture thereof. The Group IV element may be selected from the group consisting of Si, Ge and a mixture thereof. The Group IV compound may be a binary compound selected from the group consisting of SiC, SiGe and a mixture thereof.

In such cases, the binary compound, the ternary compound or the quaternary compound may be present in the quantum dot at a substantially uniform concentration. Alternatively, the binary compound, the ternary compound or the quaternary compound in a portion of the quantum dot may have a concentration different from that in another portion of the quantum dot.

Each quantum dot may have a core-shell structure comprising a core and a shell surrounding the core. Alternatively, the quantum dot may have a core/shell structure where one quantum dot surrounds another quantum dot. The interface between the shell and the core may have a concentration gradient, where the concentration of the element present in the shell is gradually decreased towards the center.

The quantum dot may be a nanoscale particle. Each quantum dot may have a full width at half maximum (FWHM) of the emission wavelength spectrum of about 45 nm or less, particularly about 40 nm or less, and more particularly about 30 nm or less, and the color purity and/or color reproducibility may be improved in such a range. Furthermore, the light emitted by the quantum dot may be output in all directions, and thus a wide viewing angle may be improved or achieved.

Furthermore, the shape of each quantum dot may be a common shape known in the art, but the shape of each quantum dot is not limited to any particular shape. For example, each quantum dot may have a spherical shape, a pyramid shape, a multi-arm shape, a cubic nanoparticle shape, a nanotube shape, a nanowire shape, a nanofiber shape or a nanoplate particle shape. The color of the light emitted by the quantum dot may be controlled depending on the particle size of the quantum dot, and thus the quantum dot may emit one of lights with various colors, such as red light, green light or blue light, particularly red light or green light.

In the present application, unless otherwise specifically indicated below, QD is used as an example for illustrating the wavelength converting material.

The QD wavelength converting unit may further comprise particles for scattering.

The QD wavelength converting unit may be formed by curing a QD ink with a ultraviolet (UV) light, and there is essentially no volume loss during the formation. As such, a QD wavelength converting unit may be prepared by filling the sub-pixel region enclosed by the bank layer with a QD ink and then curing the QD ink. Thus, the QD wavelength converting unit has a height substantially the same as the bank layer. The QD ink may be filled by ink jet printing. Or, the QD wavelength converting unit may also be prepared by coating, then performing exposure and development. As described below, when two parallel, in particular linear auxiliary banks are further provided on the bank segments, it is especially suitable to prepare the wavelength converting unit by a slit coating process.

In the present disclosure, for a bank segment between adjacent sub-pixel regions for different colors, an additional bank is provided at a side thereof away from the base substrate. That is, when adjacent sub-pixel regions are for different colors, a bank higher than the wavelength converting unit or the transparent color filtering unit is additionally provided at the bank between the adjacent sub-pixel regions. The function of the additional bank is that a light block may be formed in the transparent spacing layer of the display panel structure in Fig. 1, to prevent the light leakage and cross color between adjacent sub-pixels for different colors.

In the present disclosure, when the wavelength converting unit-containing substrate is described, for convenience, when describing the relative positions of the film layers, a side thereof close to the base substrate is considered as a bottom side for description, unless specifically indicated otherwise. For example, a side of the bank layer away from the base substrate is its top side (also referred to as an upper side), while a side thereof close to the base substrate is its bottom side (also referred to as a lower side). A direction parallel to the base substrate may be referred to as a transverse direction or a lateral direction. Accordingly, when the wavelength converting unit-containing substrate is mounted into the display panel in this direction, the backlight will come from the top side and exit the bottom side. It should be understood that all these directions are relative directions rather than absolute directions.

In the present disclosure, the bottom surface of the bank segment refers to the interface formed between the bank segment and the base substrate at its bottom side; the lateral surface of the bank segment refers to the interface formed between the bank segment and the wavelength converting unit or the transparent color filtering unit in the sub-pixel region defined thereby; and the top surface of the bank segment refers to the portion of the surface of the bank segment higher than the lateral surface.

In the present disclosure, the bottom surface of the additional bank refers to the interface formed between the additional bank and the bank layer at its bottom side or the bank layer and the auxiliary bank at its bottom side; the lateral surface of the additional bank refers to the interface formed between the additional bank and the transparent layer; and the top surface of the additional bank refers to the portion of the surface of the additional bank higher than the lateral surface.

It should be understood that there may also be a middle layer such as a surface layer or a protection layer between these surfaces. The middle layer may be considered as conformal and will not influence the above geometric division.

The additional bank is disposed between adjacent sub-pixels for different colors, higher than the wavelength converting unit or the transparent color filtering unit. In other words, the additional bank will be disposed in the transparent spacing layer, and prevent the light leakage between the sub-pixels for different colors, thereby preventing cross color.

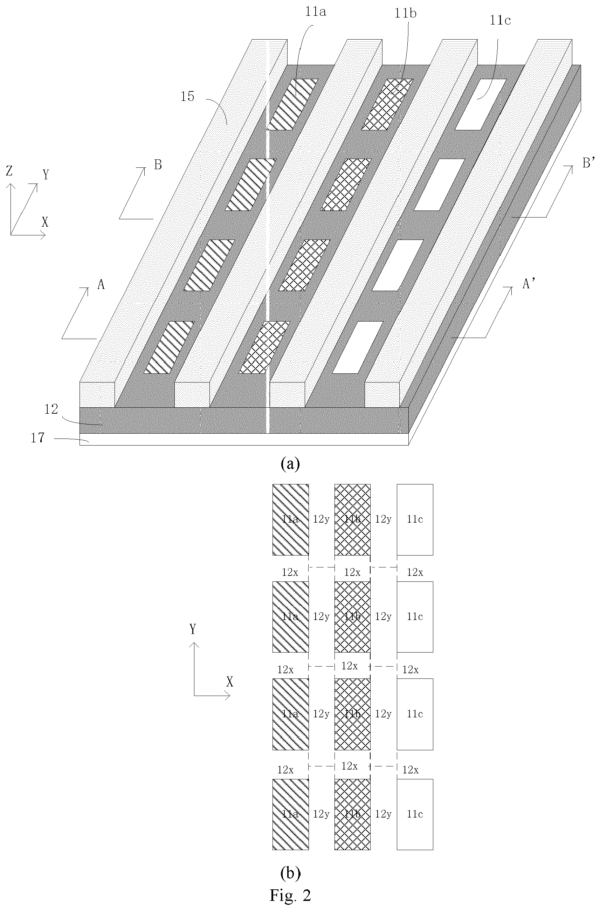

Figs. 2(a) and 2(b) show a partial schematic diagram of the pixel arrangement of an embodiment of a wavelength converting unit-containing substrate.

As shown in Fig. 2(a), the wavelength converting unit-containing substrate extends in the XY plane, and the Z direction is the height direction. When mounted into a display panel, the Z direction is a direction from the front side to the back side of the display panel, i.e., light will enter the display panel from the upper side. The wavelength converting unit-containing substrate as shown in Fig. 2 will be aligned and assembled with an array substrate, as shown in Fig. 1(b).

The wavelength converting unit-containing substrate comprises sub-pixel regions arranged in an array. The sub-pixel regions are typically arranged in a rectangular array, but may also be arranged in any other suitable array, as long as this is not in conflict with the principle of the present disclosure. For example, Fig. 2 shows sub-pixel regions which are arranged in a 3×4 rectangular array, and filled with a wavelength converting unit or a transparent color filtering unit accordingly. The rectangular array as shown in Fig. 2 may be a part of the wavelength converting unit-containing substrate. In the figure, the sub-pixel regions for different colors are designated by first sub-pixel regions 11a, second sub-pixel regions 11b, and third sub-pixel regions 11c respectively. If the X direction is a row direction and the Y direction is a column direction, the sub-pixel regions in this figure are arranged in an array of 4 rows and 3 columns. They form 4 pixels which are arranged in 1 column, with each pixel comprising 3 sub-pixel regions in the row direction. In the embodiment as shown in Fig. 2(a), the first sub-pixel region 11a, the second sub-pixel region 11b and the third sub-pixel region 11c are rectangular, and are surrounded by the bank layer 12 indicated by dark grey color around them. The bank layer 12 surrounding the sub-pixel regions comprises two bank segments extending along the X direction and two bank segments extending along the Y direction. The Y direction may be defined as a first direction, and the X direction may be defined as a second direction. Here, the sub-pixel regions for the same color are arranged along the first direction, and the sub-pixel regions for different colors are arranged along the X direction. Thus, a first direction bank segment extending along the first direction is between adjacent sub-pixel regions 11a and 11b for different colors. A second direction bank segment extending along the second direction is between sub-pixel regions 11a for the same color, or between sub-pixel regions 11b for the same color, or between sub-pixel regions 11c for the same color. The first direction bank segment and the second direction bank segment are interconnected with each other to form a grid-shaped bank layer. Fig. 2(b) shows how two bank segments 12x along the X direction and two bank segments 12y along the Y direction enclose a sub-pixel region 11b. It should be understood that the division of the bank layer at the connection between the ends of the bank segments may not be very strict, because the present disclosure focuses on the bank segment between adjacent sub-pixels, and how the ends of the bank segments are connected does not significantly influence the luminescence of the sub-pixels. Specifically, the bank layer at the connection between the ends of the bank segments, i.e., the corner of the sub-pixel, may be assigned to a suitable bank segment, as long as this is not in conflict with the technical principle of the present disclosure.

For example, the first sub-pixel region 11a may be a red sub-pixel region; the second sub-pixel region 11b may be a green sub-pixel region; and the third sub-pixel region 11c may be a blue sub-pixel region. All the sub-pixel regions are drawn in the same size. It should be understood that the color distribution, shape, size and the like of the sub-pixel regions may all be selected as appropriate, as long as they are not in conflict with the principle of the present disclosure.

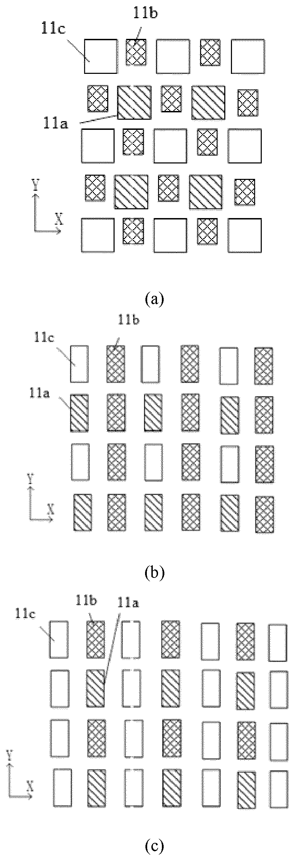

It should be understood that the arrangement of the sub-pixel regions in Fig. 2(b) is only exemplary. The arrangement of the sub-pixels for different colors is not limited in the present disclosure. For example, Figs. 3(a)-3(d) show some other possible sub-pixel arrangements.

Fig. 3(a) is a schematic plan view of the pixel arrangement of a wavelength converting unit-containing substrate provided in another embodiment of the present disclosure. As shown in Fig. 3(a), the sub-pixel regions are arranged in an array. Here, each odd column comprises the third sub-pixel regions 11c and the second sub-pixel regions 11b arranged alternately, and each even column comprises the second sub-pixel regions 11b and the first sub-pixel regions 11a arranged alternately. Meanwhile, each odd row comprises the third sub-pixel regions 11c and the second sub-pixel regions 11b arranged alternately, and each even row comprises the second sub-pixel regions 11b and the first sub-pixel regions 11a arranged alternately. For example, the first sub-pixel region 11a may be a red sub-pixel region; the second sub-pixel region 11b may be a green sub-pixel region; and the third sub-pixel region 11c may be a blue sub-pixel region.

Fig. 3(b) is a schematic plan view of the pixel arrangement of a wavelength converting unit-containing substrate provided in another embodiment of the present disclosure. As shown in Fig. 3(b), the sub-pixel regions are arranged in an array. Here, each odd column comprises the third sub-pixel regions 11c and the first sub-pixel regions 11a arranged alternately, and each even column comprises the second sub-pixel regions 11b arranged continuously. Meanwhile, each odd row comprises the third sub-pixel regions 11c and the second sub-pixel regions 11b arranged alternately, and each even row comprises the first sub-pixel regions 11a and the second sub-pixel regions 11b arranged alternately. For example, the first sub-pixel region 11a may be a red sub-pixel region; the second sub-pixel region 11b may be a green sub-pixel region; and the third sub-pixel region 11c may be a blue sub-pixel region.

Fig. 3(c) is a schematic plan view of the pixel arrangement of a wavelength converting unit-containing substrate provided in another embodiment of the present disclosure. As shown in Fig. 3(c), the sub-pixel regions are arranged in an array. Here, each odd column comprises the third sub-pixel regions 11c arranged continuously, and each even column comprises the second sub-pixel regions 11b and the first sub-pixel regions 11a arranged alternately. Meanwhile, each odd row comprises the third sub-pixel regions 11c and the second sub-pixel regions 11b arranged alternately, and each even row comprises the third sub-pixel regions 11c and the first sub-pixel regions 11a arranged alternately. For example, the first sub-pixel region 11a may be a red sub-pixel region; the second sub-pixel region 11b may be a green sub-pixel region; and the third sub-pixel region 11c may be a blue sub-pixel region.

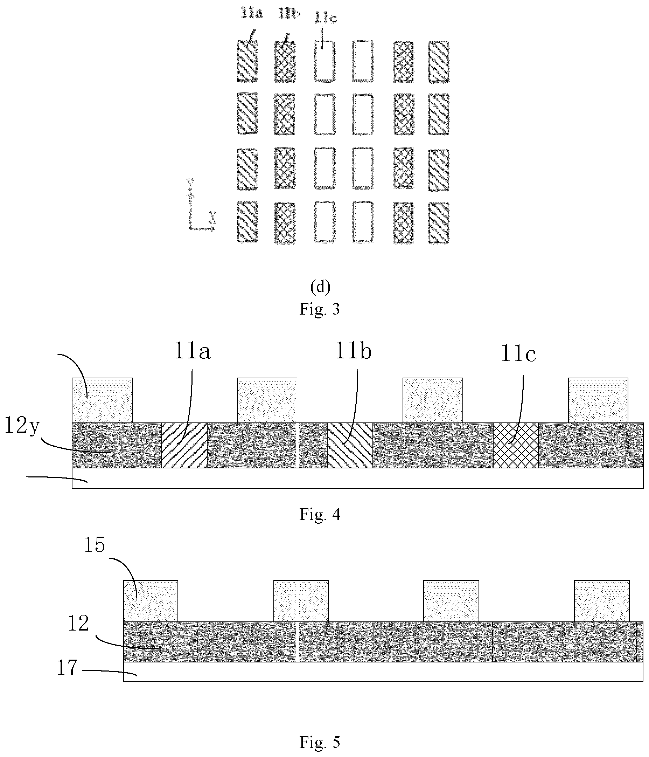

Fig. 3(d) is a schematic plan view of the pixel arrangement of a wavelength converting unit-containing substrate provided in another embodiment of the present disclosure. As shown in Fig. 3(d), the sub-pixel regions are arranged in an array. Here, each column comprises the sub-pixel regions with a single color, and each row comprises a cycle of abccba. For example, the first sub-pixel region 11a may be a red sub-pixel region; the second sub-pixel region 11b may be a green sub-pixel region; and the third sub-pixel region 11c may be a blue sub-pixel region, thereby forming the sub-pixel regions arranged in the order of RGBBGR in the row direction.

Returning back to Fig. 2(a), the bank layer 12 and the wavelength converting units or the transparent color filtering units (11a, 11b, and 11c) therein are all formed on the base substrate 17. In contrast to a conventional wavelength converting unit-containing substrate, an additional bank 15 is further formed on the bank segment 12 between adjacent sub-pixels for different colors.

Fig. 4 shows a cross sectional view taken along line A-A' in Fig. 2. The figure shows the sections of the bank segments 12 in the Y direction and the additional banks 15 thereon, and the wavelength converting unit or the transparent color filtering unit 11a, 11b, and 11c filled in the sub-pixel regions. It should be noted that unless specifically indicated otherwise, the scale in the figures of the present disclosure does not represent a real scale, and is only an example given for clarity.

The additional bank 15 is disposed at a side of the bank layer 12 away from the base substrate 17, higher than the wavelength converting unit or the transparent color filtering unit, and may effectively prevent the light leakage between the sub-pixel regions for different colors and the cross color caused by the light leakage. Furthermore, the additional bank also has a function of holding the transparent layer as described below. Also, in some embodiments, the additional bank may also function to support the array substrate and the wavelength converting unit-containing substrate.

An additional bank should be provided between the sub-pixel regions for different colors. The additional bank may also be provided between the sub-pixel regions for the same color to reduce the light leakage between the sub-pixel regions for the same color.

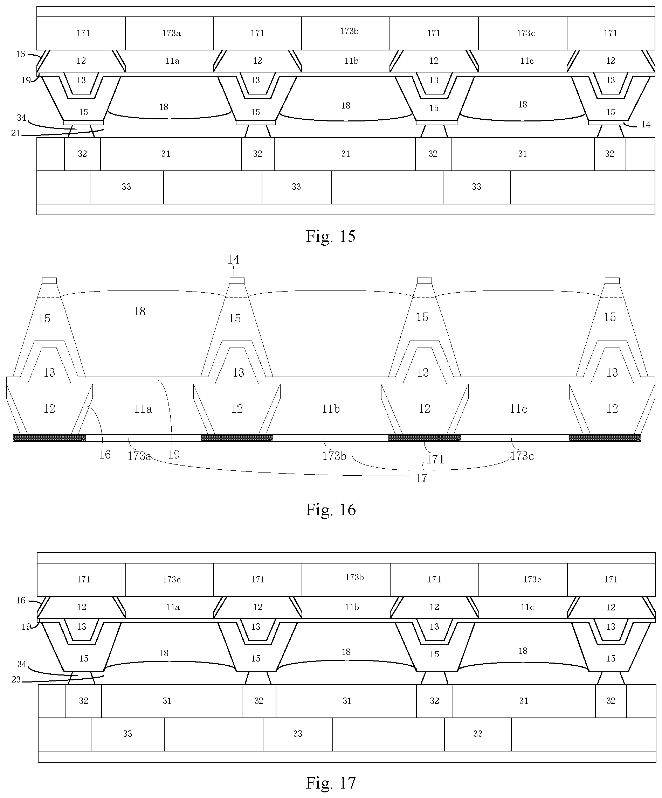

Fig. 16 shows a schematic diagram of an embodiment of a wavelength converting unit-containing substrate of the present disclosure. Here, sub-pixel regions are provided on a base substrate 17, wherein 11a is a wavelength converting unit for a first color, 11b is a wavelength converting unit for a second color, and 11c is a transparent color filtering unit for output of a light with a third color. The sub-pixel regions for different colors are spaced apart by bank segments 12. Fig. 16 shows the section of the bank segment, and the length of the bank segment extends in a direction perpendicular to the paper sheet. An additional bank 15 is provided at a side of the bank segment 12 away from the base substrate. In a particular embodiment, an orthographic projection of the additional bank 15 on the base substrate 17 is within an orthographic projection of the bank segment 12 on the base substrate 17. Accordingly, an orthographic projection of the largest width of the additional bank on the base substrate is also within an orthographic projection of the largest width of the bank segment on the base substrate.

For a bank segment between adjacent sub-pixel regions for the same color, no additional bank is provided at a side thereof away from the base substrate. The additional bank may be not provided between adjacent sub-pixels for the same color, because no obvious cross color occurs even if the light leakage occurs between adjacent sub-pixels for the same color. Fig. 5 shows a sectional view taken along line B-B' in Fig. 2, where a bank segment with an additional bank15 and a bank segment 12x without additional bank thereon are present. The section along line B-B' is taken between two sub-pixels for the same color. The dash line schematically represents the boundary of a sub-pixel region.

Since the cross color phenomena between the sub-pixel regions for the same color has no serious effect, an additional bank may be not provided on the bank layer. Without providing the additional bank, the preparation of the wavelength converting unit-containing substrate may be simplified, and the materials may also be saved.

In an embodiment, an orthographic projection of a bottom surface of the additional bank on the base substrate has a width less than that of an orthographic projection of a top surface of the bank segment between the additional bank and the base substrate on the base substrate. In this case, the orthographic projection of the bottom surface of the additional bank on the base substrate may be within the orthographic projection of the top surface of the bank segment at its bottom side on the base substrate. As such, the bottom surface of the additional bank will not block the light-incoming surface of the wavelength converting unit. Because the top of the bank segment serving as a basis for the additional bank is not wide, and the additional bank requires sufficient height, the additional bank typically has a relatively large height-to-width ratio. When the bottom of the additional bank is too narrow, the requirement on the preparation process is high, and the process is difficult. When the bottom of the additional bank is too wide, it is easy to influence the boundary of the bank layer due to process tolerance, thereby influencing the light output performance of the sub-pixel regions. Preferably, a ratio of the width of the orthographic projection of the bottom surface of the additional bank on the base substrate to the width of the orthographic projection of the top surface of the bank segment between the additional bank and the base substrate on the base substrate is in a range of [0.8, 0.9]. Thus, the width of the bottom surface of the additional bank is slightly narrower than that of the top surface of the bank below, the process is not difficult, and the sub-pixel regions will not be influenced. For example, in the case where the width of the orthographic projection of the top surface of the bank on the base substrate is around 20 µm, the width of the orthographic projection of the bottom surface of the additional bank on the base substrate may be retracted by 1 to 2 µm at both ends.

As shown in Fig. 16, the width of the orthographic projection of the bottom surface of the additional bank 15 on the base substrate is less than that of the orthographic projection of the top surface of the bank segment 12 between the additional bank 15 and the base substrate 17 on the base substrate.

In an embodiment, the additional bank comprises a black light-absorbing material. When the additional bank comprises a black light-absorbing material, both the light leakage and unwanted light reflection may be prevented. The additional bank may entirely have a light-absorbing property (for example, a black pigment is incorporated into the resin material, wherein the black pigment may include one or more of aniline black, peryene black, titanium black, carbon black and metal oxides). The additional bank may also be prepared by using a host material (such as a transparent resin) comprising no black light-absorbing material and a black light-absorbing material (such as metal molybdenum) coated on at least a portion of the outer surface of the host material. In some embodiments, the additional bank may be made from a material different from that for the bank segment on its bottom side.

In an embodiment, the additional bank has a first cross section in a direction perpendicular to a primary surface of the base substrate, and when first transversal line segments in the first cross section are taken along a direction being away from the base substrate to being close to the base substrate, there is a negative correlation between lengths of the first transversal line segments and distances from the first transversal line segments to the base substrate.

The primary surface of the base substrate is a surface with a wavelength converting unit or a transparent color filtering unit provided thereon. The first transversal line segment refers to a line segment parallel to the primary surface of the base substrate and intercepted by the first cross section. At different heights of the additional bank from the base substrate, the first transversal line segment may have the same length, or may have different lengths. For example, for an additional bank having parallel lateral walls, i.e., an additional bank having a constant width, the first transversal line segments are the same at various heights of the additional bank. Nevertheless, for an additional bank having inconstant widths, the first transversal line segments may be different at different heights of the additional bank. The direction in which the first transversal line segment extends, i.e., the orientation of the first cross section, may be arbitrary. For example, the direction in which the first transversal line segment extends may be a direction in which a line segment representing the smallest distance between adjacent sub-pixel regions extends.

When first transversal line segments in the first cross section are taken along a direction being away from the base substrate to being close to the base substrate, there is a negative correlation between lengths of the first transversal line segments and distances from the first transversal line segments to the base substrate. This means that in general, the smaller the height, the wider the additional bank is. In an embodiment, the width of the orthographic projection of the additional bank on the base substrate may be reduced continuously or stepwise from being close to the base substrate to being away from the base substrate. In a particular embodiment, the width of the orthographic projection of the top surface of the additional bank on the base substrate is less than the width of the orthographic projection of the bottom surface of the additional bank on the base substrate. For example, an additional bank which has a first cross section with a normal trapezoid or nearly normal trapezoid shape may be formed. In the present disclosure, a trapezoid, in which the top side is a short edge, the bottom side is a long edge, and two lateral sides are legs, is referred to as a normal trapezoid, and a trapezoid, in which the top side is a long edge, the bottom side is a short edge, and two lateral sides are legs, is referred to as an inverse trapezoid. The definitions for the bottom side and the top side are as described previously. When mounted into the display panel, openings which open gradually wider towards the light emitting unit above are formed on the two lateral sides of the normal trapezoid or nearly normal trapezoid additional bank, which is beneficial for the wavelength converting unit to sufficiently receive the light emitted from the light emitting unit. The additional bank (or the bank segment, or the auxiliary bank) which has a nearly normal trapezoid (or a nearly inverse trapezoid) cross section as described in the present disclosure may be understood as that its cross section has a morphology similar to a normal trapezoid (or an inverse trapezoid), while a bank form with a standard normal trapezoid (or inverse trapezoid) shape cannot be produced due to limitations on the process conditions. In the present disclosure, the expressions "first cross section" and "first transversal line segment" are used in describing the additional bank, the expressions "second cross section" and "second transversal line segment" are used in describing the auxiliary bank, and the expressions "third cross section" and "third line segment" are used in describing the bank segment. Here, "first", "second" and "third" are only for the purpose of distinguishing.

For example, the shape of the additional bank 15 as shown in Fig. 16 may be considered as the shape of its first cross section, which is a normal trapezoid. A width between two legs of the trapezoid and parallel to the top surface of the base substrate is considered as the first transversal line segment. The width is narrower at a higher position. That is, there is a negative correlation between the widths and the distances from the base substrate. In other words, the width of the orthographic projection of the additional bank on the base substrate is gradually reduced from being close to the base substrate to being away from the base substrate. The width of the orthographic projection of the top surface of the additional bank 15 on the base substrate is less than the width of the bottom surface of the additional bank on the base substrate. Accordingly, the space between the additional banks has an inverse trapezoid shape, which is beneficial for receiving more incident light from above.

In a particular embodiment, the additional bank may have a height in a range of [3 µm, 15 µm], which is beneficial for sufficiently blocking and absorbing the light leakage in the transparent spacing layer. When the height is too small, the ability of blocking the light leakage in the transparent spacing layer is insufficient. When the height is too large, it is not beneficial for obtaining a thin display panel.

In a particular embodiment, the bank layer may have a height in a range of [8 µm, 10 µm]. The height of the bank layer determines the height of the wavelength converting unit. Setting the height of the bank layer within the above range may increase the wavelength conversion efficiency of the wavelength converting unit to a desired range. When the bank is too low, the wavelength converting unit is too thin, and the light conversion may be insufficient. When the bank is too high, it would on the contrary impair the light, which has been fully converted.

In an embodiment, a lateral surface of the bank segment comprises a light reflecting layer. The light reflecting layer may reflect the light incident on the lateral wall surface in the wavelength converting unit, and make the light re-enter the wavelength converting unit, thereby increasing the optical path of the light in the wavelength converting unit and improving the light conversion efficiency. Here, the reflection may comprise specular reflection and diffuse reflection. In particular, the bank segment has a third cross section in a direction perpendicular to the primary surface of the base substrate, wherein the third cross section may have a normal trapezoid or nearly normal trapezoid shape, or the third cross section may have an inverse trapezoid or nearly inverse trapezoid shape. When the third cross section has a normal trapezoid or nearly normal trapezoid shape, the width of the wavelength converting unit of the sub-pixel region will be reduced gradually from the light-incoming side to the light-exiting side. Thus, the light reflecting layer on the lateral surface of the bank segment may reflect unconverted backlight incident on the lateral surface of the bank segment, and give the backlight an opportunity to return back into the wavelength converting unit to be converted, thereby facilitating the improvement in the wavelength conversion efficiency. When the third cross section has an inverse trapezoid or nearly inverse trapezoid shape, the width of the wavelength converting unit of the sub-pixel region will be increased gradually from the light-incoming side to the light-exiting side. At this time, the light reflecting layer on the lateral surface of the bank segment may reflect a portion of wavelength-converted light which does not travel towards the light-exiting surface to the light-exiting surface, thereby avoiding light loss while facilitating the uniformity of the output light of the sub-pixel regions.

A material for the light reflecting layer may be metal. The thickness may be selected as appropriate, and may be for example in a range of [1000 Å, 3000 Å]. Preferably, the material of Ag is used. A metal material such as Al, Ti, Mo and Ni may also be used. The metal material may be made by sputtering and etching. Preferably, the light reflecting layer is not disposed on the top surface of the bank segment to prevent abnormal light reflection caused when the light reflecting layer is on the top surface, and prevent the reduction in the adhesiveness of the additional bank and optional auxiliary bank disposed subsequently. In preparation, the reflecting layer may be formed on both the top surface and the lateral surface of the bank, and then the light reflecting layer on the top surface is removed by etching.

As shown in Fig. 16, a light reflecting layer 16 is provided on the lateral surface of the bank segment 12. Because the bank segment as shown in the figure has an inverse trapezoid shape, a portion of the light incident on the lateral surface from the wavelength converting unit such as 11a after photoluminescence may be reflected to the light-exiting surface.

The lateral surface of the additional bank may also comprise a light reflecting layer, such that the light incident on the lateral surface of the additional bank may be reflected into the wavelength converting portion, thereby further increasing the utilization ratio of the light. The material and thickness of the light reflecting layer on the lateral surface of the additional bank may be in the same selection ranges for those of the light reflecting layer on the lateral surface of the bank segment.

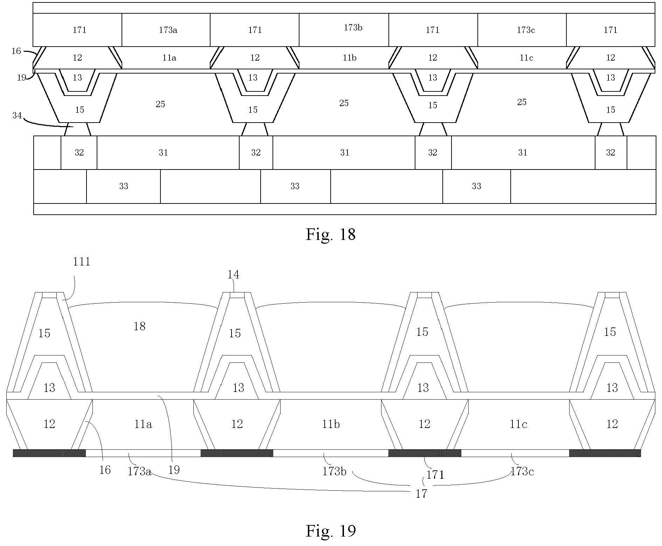

Fig. 19 schematically shows an embodiment of a wavelength converting unit-containing substrate where a light reflecting layer is provided on the lateral surface of the additional bank. The embodiment in Fig. 19 is similar to that in Fig. 16, except that a light reflecting layer 111 is provided on the lateral surface of the additional bank in Fig. 19.

Furthermore, a light scattering layer may also be provided on the lateral surface of the bank segment. An organic resin material having a scattering function may be selected for the light scattering layer. The resin material may be made by coating and developing. The light reflecting layer may be overlaid with the light scattering layer to make the reflected light more uniform.

In an embodiment, the wavelength converting unit-containing substrate further comprises a transparent layer, wherein the transparent layer is separated into transparent portions by the additional banks. In some embodiments, the transparent portion is a gas-filled portion which may have a refractive index of 1. In some embodiments, the transparent portion comprises a transparent solid material, and has a refractive index greater than 1. For example, the transparent portion may have a refractive index between 1.4 and 1.5. In some embodiments, the transparent portion may be in contact with the aligned and assembled array substrate, and may function to maintain the distance between the light emitting unit and the wavelength converting unit. In some embodiments, a curved surface is provided at a side of the transparent portion away from the substrate, which may function as a lens to converge the light emitted by the light emitting unit, thereby improving the luminous effect.

As shown in Fig. 16, a transparent portion 18 is further provided between the additional banks 15. When mounted into the display panel, the backlight will first be transmitted through the transparent portion 18 and then enter the sub-pixel regions.

In an embodiment, at least a part of the transparent portions have a convex lens morphology. In other words, the convex top surface of the transparent layer forms a convex lens capable of converging light. The convex lens may function to converge the light emitted by the light emitting unit, thereby increasing the utilization ratio of the backlight. For example, a portion of the light output from the vicinity of the right end of the light emitting unit of a sub-pixel will be incident onto the vicinity of the left end of the transparent portion of the sub-pixel. Such light has a large angle, and cannot be refracted to the light-incoming surface of the wavelength converting portion. When a convex lens is present, a portion of such light having a large angle may be refracted to the light-incoming surface of the wavelength converting portion, thereby increasing the utilization ratio of the backlight. The particular shape of the convex lens is not limited, as long as the convex lens may converge the backlight.

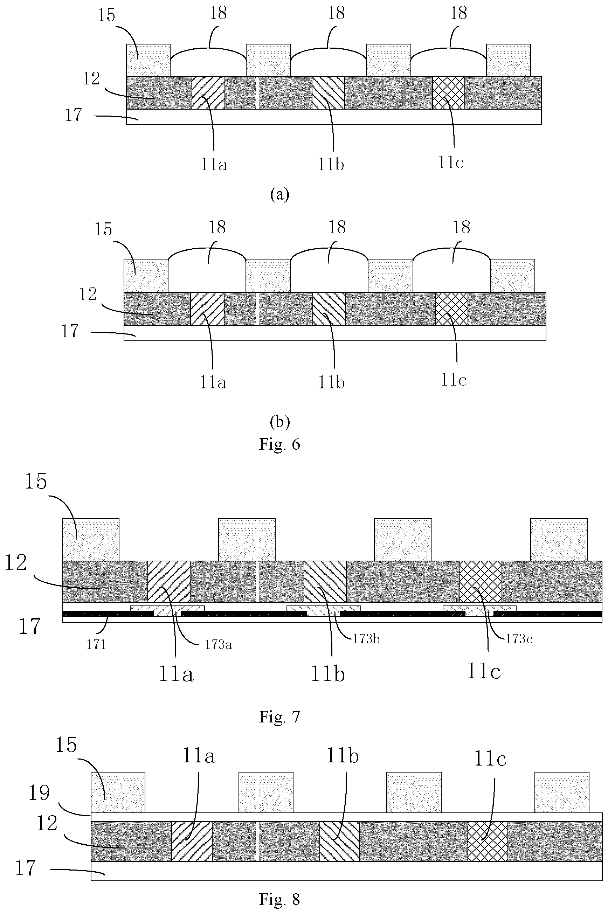

Figs. 6(a) and 6(b) schematically show the situations where a transparent portion 18 in a wavelength converting unit-containing substrate has a relatively high apex and forms a convex lens. The apex of the transparent portion 18 in Fig. 6(a) is lower than the apex of the additional bank 15, and the apex of the transparent portion 18 in Fig. 6(b) is higher than the apex of the additional bank 15. As shown in Figs. 6(a) and (b), the top of the transparent portion 18 will be used as the light-incoming surface. As compared to a planar top surface of the transparent portion with the same light-incoming opening, a portion of the incident light ought to be incident on the lateral surface of the additional bank 15 and thus be absorbed and lost may be refracted to the smaller light-exiting surface of the bottom surface of the transparent portion 18, so as to enter the sub-pixel region, thereby increasing the light output efficiency. In view of preventing the light leaked from an adjacent pixel from reaching the top surface of the transparent portion, the embodiment in Fig. 6(a) is better, because the additional bank may block more leaked light.

The light converging function of the transparent portion 18 may also be achieved by designing its top surface to be a concave surface and cooperatively providing a transparent filler with relatively high refractive index between the top surface and the array substrate.

In an embodiment, a lyophobic layer is provided on the top surface of the additional bank, and when preparing the transparent layer, the lyophobic layer exhibits a lyophobic property to the transparent filler used in preparing the transparent layer, such that the top of the additional banks will not be wetted after sufficiently filling an organic transparent filler between the additional banks. When the organic transparent filler is filled in the space between the additional banks, the liquid level of the organic transparent filler may form a centrally convex transparent layer, which naturally forms a convex lens morphology, due to the lyophobic property of top surface of the additional bank. A typical organic transparent filler is an epoxy resin or an acrylic resin. Thus, in an embodiment, the contact angle of the epoxy resin or the acrylic resin on the top surface of the additional bank is greater than or equal to 90°.

Preferably, in order to sufficiently filling the organic transparent filler, at least a portion of the lateral surface of the additional bank has no lyophobic property to the organic transparent filler. Specifically, the lateral surface of the additional bank comprises a lateral surface close to the bank segment and a lateral surface close to the top surface. In some embodiments, the lateral surface close to the bank segment has no lyophobic property to the organic transparent filler, such that the organic transparent filler is sufficiently filled. Preferably, a ratio of the height of the lateral surface comprised in the lateral surface of the additional bank and having no lyophobic property to the organic transparent filler to the height of the additional bank is greater than or equal to 0.5, such that it may be ensured that the organic transparent filler is sufficiently filled. In some embodiments, the lateral surface close to the top surface and the top surface have a lyophobic property to the organic transparent filler, such that the organic transparent filler is filled excessively and forms a convex lens morphology. Preferably, a ratio of the height of the lateral surface comprised in the lateral surface of the additional bank and having no lyophobic property to the organic transparent filler to the height of the additional bank is less than or equal to 0.9, and the rest part of the lateral surface has a lyophobic property to the organic transparent filler, ensuring that the organic transparent filler is filled. The lateral surface close to the top surface and having a lyophobic property facilitates the formation of the embodiment in Fig. 6(a), which has a convex lens surface while the surface is lower than the top surface of the additional bank. Specifically, the lyophobic layer may be a surface which the additional bank itself has, that is, the material of the additional bank has a lyophobic property, or alternatively, may be an additionally fabricated film layer having a lyophobic property.

As shown in Fig. 16, the top surface 14 of the additional bank 15 has a lyophobic property to the material of the transparent portion 18, and a portion of the lateral surface of the additional bank 15 close to the top surface (above the dashed line) also has a lyophobic property. Thus, the organic transparent filler may form a transparent portion 18 having a convex surface. The lateral surface of the additional bank below the lyophobic layer may be non-lyophobic with respect to the organic transparent filler.

In an embodiment, the maximum distance between at least one transparent portion having a convex lens morphology and the base substrate is less than the maximum distance between its adjacent additional bank and the base substrate. In other words, the apex of the transparent layer is lower than the apex of the additional bank.

In an embodiment, the maximum distance between at least one transparent portion having a convex lens morphology and the base substrate is greater than the maximum distance between its adjacent additional bank and the base substrate. In other words, the apex of the transparent layer is higher than the apex of the additional bank.

In an embodiment, the base substrate comprises a color filter layer comprising a black matrix and color filters in spaces enclosed by the black matrix, wherein an orthographic projection of the bank segment on the base substrate is within an orthographic projection of the black matrix on the base substrate, and a ratio of a width of an orthographic projection of a bottom surface of the bank segment on the base substrate to a width of an orthographic projection of the black matrix on the base substrate is in a range of [0.8, 0.9].

The color filter unit may further purify the color of the emergent light from the sub-pixel by filtering light, while preventing external light from entering the wavelength converting unit or the transparent color filtering unit, thereby improving the display effect. Fig. 7 schematically shows an embodiment of a wavelength converting unit-containing substrate comprising a color filter layer, which comprises a wavelength converting unit-containing substrate comprising color filter units 173a, 173b and 173c and a black matrix 171. In the present disclosure, it is particularly advantageous that a ratio of the width of the orthographic projection of the bottom surface of the bank segment on the base substrate to the width of the orthographic projection of the black matrix on the base substrate is in a range of [0.8, 0.9]. The bank segment is required to have sufficient adhesive force to the black matrix portion. When the above width ratio is too small, the adhesive force will be not sufficient. When the above width ratio is too large, the color filter between the black matrices will be easily blocked due to the process tolerance. For example, when the black matrix has a width of 50 µm, the both ends of the width of the projection of the bottom surface of the bank segment on the base substrate black matrix may be retracted by a value in a range of [3 µm, 5 µm] relative to the both ends of the width of the projection of the black matrix on the base substrate at each side.

The black matrix and the color filter in the color filter layer may be prepared by conventional processes. Typically, a black matrix (BM) adhesive with black color is applied on the base substrate, and patterned by performing exposure and development with a mask, to form the light-exit opening of the sub-pixel. Then, red, green and blue photoresists are applied, and patterned by performing exposure and development, to form color filters.

As shown in Fig. 16, the orthographic projection of the bottom surface of the bank segment 12 on the base substrate 17 has a width less than that of the orthographic projection of the black matrix 171 on the base substrate 17.

In an embodiment, the wavelength converting unit-containing substrate further comprises a protection layer under the additional bank and covering the plurality of sub-pixel regions and the bank layer. In other words, the protection layer is provided between the bank layer and the additional bank. After the sub-pixel region enclosed by the bank is filled and the wavelength converting unit or the transparent color filtering unit is formed, the protection layer may cover them, so as to prevent the fabricated film layers from being affected by subsequent film layer preparation. Meanwhile, the protection layer functions to protect the wavelength converting unit or the transparent color filtering unit, so as to prevent it from being damaged by water and oxygen in the environment. Generally, SiNx or SiO₂ may be prepared as a protection layer by Chemical Vapor Deposition (CVD). Also, an aluminum oxide layer may be prepared as a protection layer by Atom Layer Deposition (ALD). The material and thickness of the protection layer may be selected as appropriate.

Fig. 8 schematically shows an embodiment of a wavelength converting unit-containing substrate comprising a protection layer. Here, the protection layer 19 is present between the bank layer 12 and the additional bank 15, and covers the bank layer and the sub-pixel region.

As shown in Fig. 16, the bank layer 12 and the sub-pixel are covered by a protection layer 19 at a side thereof away from the base substrate. An additional bank 15 and a transparent portion 18 are further provided at a side of the protection layer 19 away from the base substrate.

For the bank segment between the adjacent sub-pixel regions for different colors, an auxiliary bank is further provided on the side thereof away from the base substrate, and is between the bank segment and the additional bank, wherein an orthographic projection of the auxiliary bank on the base substrate has a width less than that of an orthographic projection of the additional bank on the base substrate, and a maximum distance between the auxiliary bank and the base substrate is greater than a minimum distance between the additional bank and the base substrate.

In a particular embodiment, the orthographic projection of the auxiliary bank on the base substrate is within the orthographic projection of the additional bank on the base substrate.

The auxiliary bank is a bank between the bank layer and the additional bank, and one of its main functions is to increase the binding force between the additional bank and the bank layer. Generally, the top surface of the bank layer is a planar surface or a surface with slightly protruded center. In this case, an insufficient binding force between the bottom surface of the additional bank and the top surface of the bank layer or the protection layer on the top surface of the bank layer may be caused either by directly forming the additional bank on the top surface of the bank layer or by forming the additional bank after covering the top surface by the protection layer first. The additional bank tends to be detached from the structure below, or to slide in the width direction.

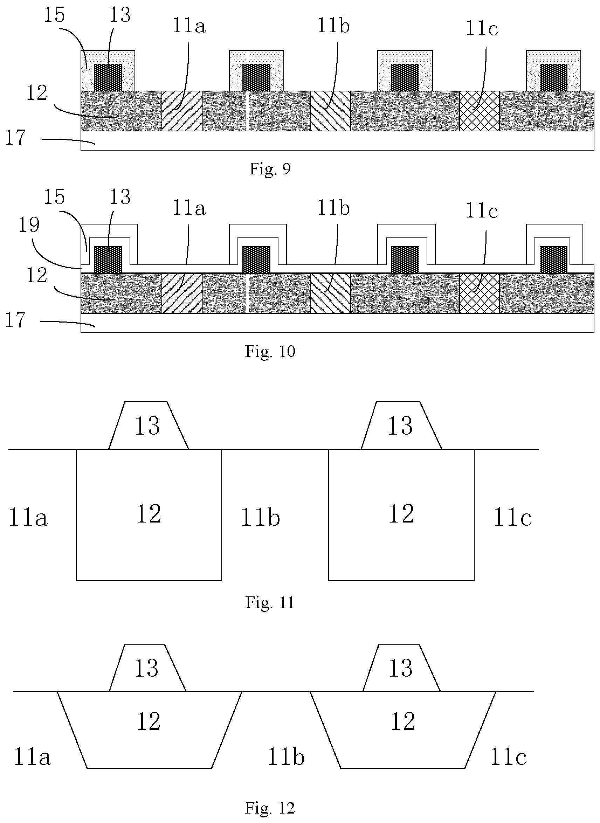

Fig. 9 schematically shows an embodiment of a wavelength converting unit-containing substrate comprising an auxiliary bank. As shown in Fig. 9, the present disclosure proposes to form an auxiliary bank 13 above the top surface of the bank segment 12. The auxiliary bank 13 has a bottom surface narrower than the top surface of the bank segment 12, and protrudes in a direction away from the base substrate. Therefore, a space for forming the additional bank 15 is left on the lateral surface of the auxiliary bank. Then, the additional bank 15 is formed not only on the top surface of the auxiliary bank 3, but also on the lateral surface of the auxiliary bank 13. In other words, the maximum distance between the auxiliary bank and the base substrate is greater than the minimum distance between the additional bank and the base substrate. Thus, it is equivalent to "inserting" a "wedge" shaped fixing component into the bottom surface of the additional bank 15, such that the additional bank 15 will not easily be detached from the structure below or slide in the width direction.

The important functions of the auxiliary bank also include that it may form a blocking structure higher than the bank segment between the sub-pixel regions for different colors, which facilitates preventing the coating material from being mixed across the bank segment when preparing the wavelength converting unit or the transparent color filtering unit by a coating process, so as to solve the problem of the mixing of various colors of the sub-pixel regions.

As shown in Fig. 16, the auxiliary bank 13 is formed at a side of the bank segment 12 away from the base substrate, and forms a wedge-shaped structure inserted into the bottom of the additional bank 15, thereby effectively fixing the additional bank 15.

In an embodiment, the aforementioned protection layer of the wavelength converting unit-containing substrate covers the wavelength converting unit, the bank layer and the auxiliary bank at the same time. Fig. 10 schematically shows an embodiment comprising both a protection layer and an auxiliary bank. A bank layer and an auxiliary bank may be firstly formed, then, a wavelength converting unit may be formed, subsequently, a protection layer may cover them, and then an additional bank may be further formed on the protection layer over the bank.

As shown in Fig. 16, the protection layer 19 covers not only the bank segment 12 and the sub-pixel region, but also the auxiliary bank 13. The auxiliary bank is formed before being covered by the protection layer. On one hand, the auxiliary bank may be more firmly bound to the bank segment when it is directly formed on the bank segment. On the other hand, the auxiliary bank may also be configured for forming the wavelength converting unit by a coating process, while the protection layer has to covering the wavelength converting unit after it is formed.

In an embodiment, the auxiliary bank has a second cross section in a direction perpendicular to a primary surface of the base substrate, and when second transversal line segments in the second cross section are taken along a direction from being away from the base substrate to being close to the base substrate, there is a negative correlation between lengths of the second transversal line segments and distances from the second transversal line segments to the base substrate. The meanings for the second cross section and the second transversal line segment are as described above with respect to the first cross section and the first transversal line segment. In an embodiment, the widths of the orthographic projections of the auxiliary banks on the base substrate are gradually reduced from being close to the base substrate to being away from the base substrate. Or, the orthographic projection of the top surface of the auxiliary bank on the base substrate is smaller than the orthographic projection of the bottom surface of the auxiliary bank on the base substrate. Typically, the second cross section may have a normal trapezoid or nearly normal trapezoid shape. Fig. 11 schematically shows a normal trapezoid auxiliary bank. For an auxiliary bank which typically has a very small size, the preparation process for a normal trapezoid auxiliary bank is significantly simple. Furthermore, the auxiliary bank should leave a space for forming the additional bank at its lateral surfaces. Thus, if it is formed as an inverse trapezoid, either the space for the additional bank at the lateral surface will be greatly reduced, or the firmness will be reduced due to smaller bottom. Furthermore, the normal trapezoid auxiliary bank is advantageous for filling the wavelength converting material or the transparent color filtering material by slit coating as described below, because the bank of this shape is advantageous for blocking the coated material in its corresponding sub-pixel region.

In an embodiment, the width of the auxiliary bank may also be gradually increased from being close to the base substrate to being away from the base substrate. Specifically, the second cross section may have an inverse trapezoid or nearly inverse trapezoid shape. The inverse trapezoid or nearly inverse trapezoid auxiliary bank may provide stronger fixing effect for the additional bank formed subsequently.

As shown in Fig. 16, the width of the orthographic projection of the auxiliary bank 13 on the base substrate is gradually reduced from being close to the base substrate to being away from the base substrate. This shape is easy to prepare, and leaves a space for the additional bank while having sufficient firmness. It is also advantageous as a blocking structure, which is advantageous for accumulating the coated material in its corresponding sub-pixel region, so as to prevent the material from crossing the boundary.

The auxiliary bank preferably has a lyophobic property to the filling material such as a QD ink in the sub-pixel region, so as to facilitate accumulation of the material in the sub-pixel region. In an embodiment, a material having a lyophobic property to the QD ink is selected for forming the auxiliary bank.

In an embodiment, the bank segment has a third cross section in a direction perpendicular to a primary surface of the base substrate, and when third transversal line segments in the third cross section are taken along a direction from being away from the base substrate to being close to the base substrate, there is a negative correlation between lengths of the third transversal line segments and distances from the third transversal line segments to the base substrate. The meanings for the third cross section and the third line segment are as described above with respect to the first cross section and the first transversal line segment. In an embodiment, the width of the orthographic projection of the bank segment on the base substrate is gradually increased from being close to the base substrate to being away from the base substrate. Or, the orthographic projection of the top surface of the bank segment on the base substrate is larger than the orthographic projection of the bottom surface of the auxiliary bank on the base substrate. Specifically, the third cross section has a shape different from that of the first cross section. The third cross section has an inverse trapezoid or nearly inverse trapezoid shape, while the first cross section has a normal trapezoid or nearly normal trapezoid shape. Fig. 12 schematically shows an inverse trapezoid bank. Because the wavelength converting unit or the transparent color filtering unit is in the sub-pixel region defined by the bank segment, it will be very advantageous for enhancing light output if a light reflecting layer is provide on the lateral surface of the inverse trapezoid bank segment.

As described above, the bank segment preferably has a height in a range from 8 to 10 µm. In order that the inverse trapezoid bank segment has a good adhesive force on the base substrate such as a black matrix, the bottom width of the inverse trapezoid bank segment cannot be too small. In an embodiment, its bottom has a width in a range from 10 to 20 µm, preferably of about 15 µm. The width of the orthographic projection of the oblique edge of the inverse trapezoid on the base substrate preferably should not be more than a half of the width of the bottom of the inverse trapezoid on the base substrate, so as to increase the firmness of the structure, that is, it is in a range from 5 to 10 µm, and preferably about 5 µm. In this case, its top may have a width of about 20 µm. The both ends of the width of the orthographic projection of the bottom of the additional bank above it on the base substrate may be retracted by a value in a range of [1 µm, 2 µm] relative to the both ends of the width of the orthographic projection of the top of the bank segment on the base substrate at each side, as described above.

As shown in Fig. 16, the width of the orthographic projection of the bank segment 12 on the base substrate is gradually increased from being close to the base substrate to being away from the base substrate.

The combination of the inverse trapezoid bank and the normal trapezoid auxiliary bank thereon as shown in Fig. 12 has all the aforementioned advantages. Such a structure may be prepared by coating photoresist twice and performing exposure and development twice respectively. Preferably, the bank segment and the auxiliary bank are integrated. The bank segment and the auxiliary bank formed integrally allow the auxiliary bank to have particularly good binding property with the bank segment, such that they are more firm, and may better serve as a fixture for the additional bank. The combined structure of the bank and the auxiliary bank having a shape as shown in Fig. 12 may be achieved by exposure once with a halftone mask. First, an uncured material for the bank layer is applied to a thickness which equals to the sum of the heights of the bank and the auxiliary bank. Then, the material is exposed with a halftone mask, with the sub-pixel region covered by the completely opaque mask and the top of the auxiliary bank not covered by the mask at all. The transmittance to the light ray for curing such as ultraviolet light is adjusted appropriately for the region between those two regions, thereby finally forming the lateral surface of the auxiliary bank and the top surface stage of the bank layer with varied exposure degrees. When the material of the bank layer is a light-absorbing material (such as a dark grey material, particularly preferably a black material) and is thick enough, the bottom edge of the bank layer is not sufficiently exposed and cannot be cured, and thus an undercut retraction is naturally formed after developing, such that the inverse trapezoid bank layer and the normal trapezoid auxiliary bank may be formed by performing exposure and development once. In this case, particular process parameters for integrally forming the bank segment and the auxiliary bank by exposure once are related to the materials used.

The bank segment 12 and the auxiliary bank on the side thereof away from the base substrate as shown in Fig. 16 are integrated, although a boundary is drawn therebetween. They are made from the same material, and actually there may be no interface therebetween.

In an embodiment, the auxiliary bank has a height in a range of [2 µm, 5 µm]. The auxiliary bank with such a height is easy to be formed, binds firmly to the bank below, and provides sufficient fixing effect for the additional bank above. If the height is too small, the fixing effect for the additional bank may be insufficient. Because its bottom surface has a small absolute area, when the height is too large, the difficulty of the preparation process is increased and the auxiliary bank itself may become not firm.

In an embodiment, a ratio of a width of an orthographic projection of a bottom surface of the auxiliary bank on the base substrate to a width of an orthographic projection of a top surface of the bank segment between the auxiliary bank and the base substrate on the base substrate is in a range of [30%, 50%]. Such a range allows the auxiliary bank to bind firmly to the bank, and also leaves sufficient space for forming the additional bank covering the auxiliary bank at the lateral surfaces.

A plurality of sub-pixel regions for the same color are continuously arranged to form a group of sub-pixel regions, the auxiliary banks between the group of sub-pixel regions and sub-pixel regions adjacent thereto form a continuous auxiliary bank, and no auxiliary bank is provided within the group of sub-pixel regions.

The expression "continuously arranged " means that each sub-pixel in the group of sub-pixel regions at least has one adjacent sub-pixel for the same color. Typically, Fig. 2(b) shows three groups of such sub-pixel regions. In Figs. 3(b) and 3(c), 11b and 11c form such groups of sub-pixel regions respectively. In Fig. 3(d), 11a, 11b and 11c form such groups of sub-pixel regions respectively, and in the left-right direction, the sub-pixel regions of 11c and 11a are wider than the sub-pixel region of 11b, and each comprises two sub-pixels. No such group of sub-pixel region is present in Fig. 3(a).

Preferably, the sub-pixels in one group of sub-pixel regions are arranged in line. Nevertheless, they may also be arranged not in line.

The auxiliary bank for separating one group of sub-pixel regions from an adjacent sub-pixel for a different color is continuous, such that blocking is provided by the auxiliary bank between the entire group of sub-pixel regions and surrounding sub-pixel regions. However, within one group of sub-pixel regions, no blocking is provided by the auxiliary bank on the bank segment between sub-pixel regions.

Accordingly, an additional bank is provided on the auxiliary bank above the bank segment between adjacent sub-pixel regions for different colors, while no additional bank is provided on the bank segment between adjacent sub-pixel regions for the same color.

The continuous auxiliary bank separates the group of sub-pixel regions from the sub-pixel regions for different colors. This is advantageous for filling the wavelength converting unit or the transparent color filtering unit by directly coating rather than ink jet printing or lithographic patterning. Conventionally, when the wavelength converting unit such as a QD material is filled into the sub-pixel region defined by the bank layer, ink jet printing or lithographic patterning will be used, but direct extrusion coating such as slit coating cannot be used because this easily causes excessive QD material to overflow into an adjacent sub-pixel region in which no such material is needed to be coated. However, the blocking of nozzle easily occurs in ink jet printing, and lithographic patterning requires a mask with a high accuracy and causes a large amount of material to be wasted due to subtractive manufacture. In the present disclosure, when a continuous auxiliary bank is present, it blocks excessive QD material, and prevents the material from overflowing into an adjacent sub-pixel region. Therefore, the QD material may be directly applied in sub-pixel regions in the same group conveniently without influencing adjacent sub-pixel regions. In this method, the coating amount and accuracy are not strictly limited. Although there is a small amount of excessive QD material covering the top surface of the bank segment, the wasted material caused thereby is much less than that caused by lithographic patterning. Therefore, the process of providing a continuous auxiliary bank may save cost significantly. The QD material covering the top surface of the bank segment will not adversely affect luminescence.

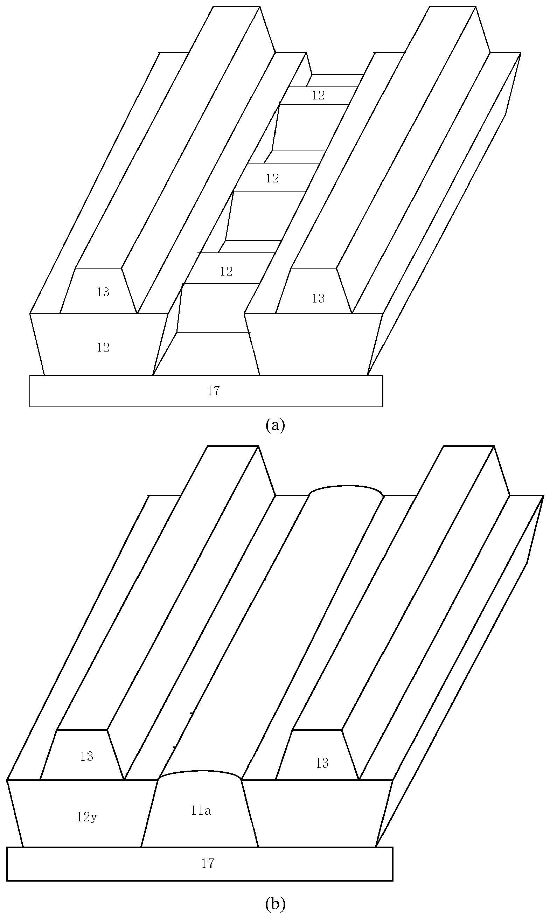

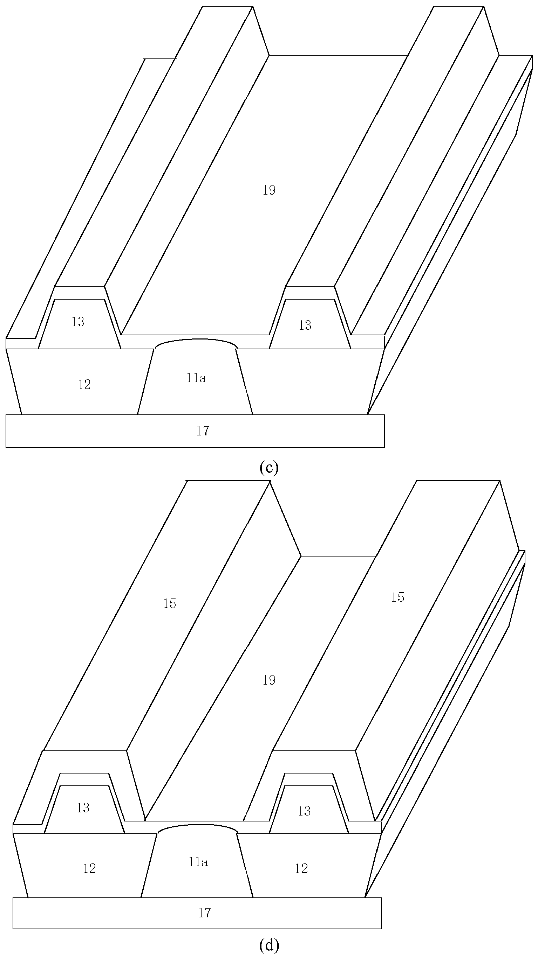

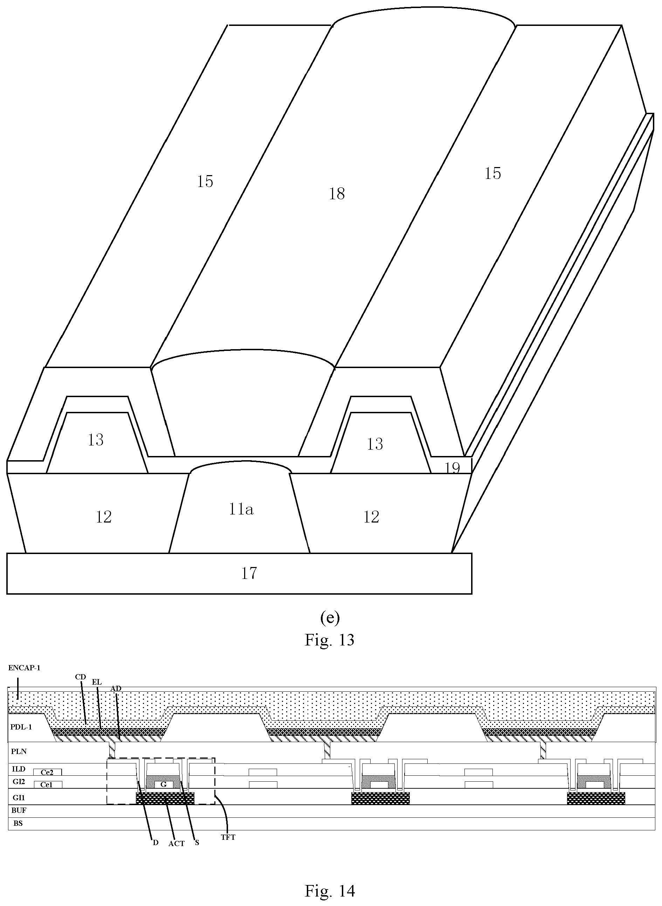

Figs. 13(a)-13(e) schematically show a process for forming an embodiment of a wavelength converting unit-containing substrate. The reference numbers used in these figures are the same as those in previous figures. Fig. 13(a) shows a wavelength converting unit-containing substrate where no QD material has been filled and no protection layer or additional bank covers it. Fig. 13(b) shows that the QD material has been filled by coating. Here, even though some QD material remains on the top of the bank layer, this will not significantly affect the display effect. Fig. 13(c) shows the protection layer covering it. Fig. 13(d) shows that the additional bank has been formed. Fig. 13(e) shows that a transparent layer is further filled. The transparent layer forms a columnar convex lens shape, and has a top higher than the top of the additional bank. This may be achieved by providing a layer lyophobic to the material of the transparent layer on the top of the additional bank.

In an embodiment, the continuous auxiliary bank forms two parallel banks at both flanks of the group of sub-pixel regions. The two parallel banks will form an area, which may be coated and maintains a certain width, which is particularly suitable for coating with a slit coater. The slit coater has a high automation degree, and also has a large opening, which will not be easily blocked. Also, the structure is relatively simple, and will be easily cleaned even if it is blocked. By providing linear auxiliary banks, the use of slit coating may reduce the cost for forming the sub-pixel region by 80% or more than ink jet printing or lithographic patterning. The two parallel banks may comprise corners, that is, the parallel banks change the direction at the same time and keep a constant distance. Accordingly, the nozzle of the slit coater may be not only moved along a straight line, but also turn a corner along the trend of the banks during the movement. However, more preferably, the two parallel banks are two parallel linear banks, that is, a liner area to be slit coated is provided, such that the nozzle of the slit coater is only needed to move linearly, thereby further reducing the process difficulty. Various sub-pixel arrangements may be suitable for the present embodiment. For example, in the pixel arrangements of Fig. 2(b) and Fig. 3(d), all the sub-pixel regions with three kinds of colors may form a group respectively, and are particularly advantageous to be prepared by slit coating. Especially for the pixel arrangement of Fig. 3(d), two columns of sub-pixels 11a or 11c may be slit coated at one time.

Of course, for example, for the pixel arrangement of Fig. 3(a), no group of sub-pixel regions may be provided. Nevertheless, the presence of the auxiliary bank is still advantageous for fixing the additional bank.

In some embodiments, the continuous auxiliary bank is distributed uniformly across the wavelength converting unit-containing substrate. Specifically, the continuous auxiliary banks are spaced apart by a sub-pixel region. For example, for the pixel arrangement of Fig. 3(d), the wavelength converting unit-containing substrate comprises two adjacent third sub-pixel regions 11c in the row direction, and the sub-pixel regions 11c are continuously distributed in the column direction. A continuous auxiliary bank may also be provided between the two columns of third sub-pixel regions 11c, such that the two columns of third sub-pixel regions 11c are spaced apart by the auxiliary bank. It will not influence the coating of the slit coater to space the two columns of third sub-pixel regions 11c apart by the auxiliary bank. In some embodiments, an additional bank is also provided at a side of the auxiliary bank between the two columns of third sub-pixel regions 11c away from the base substrate, and the auxiliary bank functions to fix the additional bank. In some embodiments, when the wavelength converting unit-containing substrate comprises a transparent portion, the continuous auxiliary bank uniformly distributed is advantageous for a uniform morphology of the transparent portion, thereby reducing the effect of a non-uniform morphology of the transparent portion wavelength converting unit-containing substrate on the light output effect.

In an embodiment, the different colors comprises red, green and blue, wherein a red sub-pixel region is filled with a wavelength converting unit containing a red quantum dot material, a green sub-pixel region is filled with a wavelength converting unit containing a green quantum dot material, and a blue sub-pixel region is filled with a wavelength converting unit containing a blue quantum dot material or a transparent color filtering unit. For example, a quantum dot (QD) wavelength converting unit may be used for forming a QD-OLED display panel.

In an embodiment, a display panel comprises the aforementioned wavelength converting unit-containing substrate and an array substrate aligned and assembled with the wavelength converting unit-containing substrate.

In an embodiment, the display panel comprises:
an array substrate, wherein the array substrate comprises a pixel defining layer and light emitting units in spaces enclosed by the pixel defining layer, and
the wavelength converting unit-containing substrate as described previously aligned with the array substrate,
wherein the display panel comprises sub-pixels arranged in an array, wherein each of the sub-pixels comprises one light emitting unit in the array substrate and one wavelength converting unit or transparent color filtering unit in the wavelength converting unit-containing substrate, and the light emitting unit is disposed to be overlapped by the wavelength converting unit or transparent color filtering unit.

The array substrate may be an array substrate available in related art. For example, it may be an OLED light emitting substrate, a QLED light emitting substrate, a Mini-LED light emitting substrate, a Micro-LED light emitting substrate, or a LCD array substrate, as long as it may be combined with the wavelength converting unit-containing substrate of the present disclosure. For example, Fig. 14 shows an embodiment of an array substrate. The figure shows a partial schematic diagram of a structure comprising 3 complete OLED light emitting units and 4 pixel defining layers (PDL-1). A buffer layer BUF is provided on the base substrate BS. On the buffer layer, each sub-pixel is provided with a TFT unit. The TFT unit comprises a source electrode S, a drain electrode D, a gate electrode G, and an active layer ACT. A first gate electrode insulating layer GI1 is provided below the gate electrode and between the gate electrode and the active layer, and a second gate electrode insulating layer GI2 is overlaid on the gate electrode and its periphery. An interlayer dielectric layer ILD and a planarization layer PLN are provided in sequence on the second gate electrode insulating layer. Enable signal wires Ce1 and Ce2 are further provided on the second insulating layer and the interlayer dielectric layer. A light emitting unit is formed on the planarization layer between the pixel defining layers PDL-1. The light emitting unit comprises an anode AD, an organic light emitting portion EL and a cathode CD from bottom side to top side. The anode is connected to the drain electrode of the TFT, and the cathode is a common electrode. A first encapsulation layer Encap-1 is further provided on the cathode. The first encapsulation layer is disposed at a side of the light emitting layer close to the wavelength converting layer. The structure of the OLED light emitting unit as described above is known in the art, and comprises an anode, an organic light emitting layer, a cathode, and so on. In Fig. 14, the anode AD of the light emitting unit may be a reflecting anode which reflects the light emitted by the OLED upwards to increase the light output efficiency. Furthermore, in contrast to the multi-color OLED array, the light emitting layer of the present disclosure only has a light emitting material layer with one color, and thus may be formed on the entire surface with an open mask without forming the sub-pixels one by one by using a fine metal mask, for example. An orthographic projection of the TFT on the base substrate may be overlapped with both the PDL-1 and the light emitting unit. That is, one portion of the TFT may also be positioned below the PDL-1, and another portion may be positioned below the reflecting anode. The substrate may be assembled with the color filter of the present disclosure in the manner as shown in Fig. 1(b) with the sub-pixel positions aligned, to form a display panel.

An encapsulation layer is provided on the anode to protect the array substrate. The encapsulation layer may be a stack of multiple layers of films.

In some embodiments, when the distance between the array substrate and the wavelength converting unit-containing substrate is greater than a supporting height which may be provided by the additional bank, a supporter may be additionally provided to support those two substrates. The supporter may be provided on the array substrate, aligned with at least a portion of the additional banks, and will be in contact with the additional bank in cell alignment. In the case where the transparent portion has the aforementioned convex lens surface morphology, when the maximum distance between the surface of the transparent portion and the base substrate is greater than the maximum distance between the additional bank and base substrate (i.e., when the apex of the convex lens is higher than the top surface of the additional bank), the supporting portion may prevent the damage to the transparent portion during cell alignment. Nevertheless, it should be avoided as much as possible that the transparent portion with a convex lens morphology is higher than the additional bank, so as to prevent it from collecting the leaked light with a large angle. Preferably, the supporter is also prepared from a light-absorbing material.

When the maximum distance between the transparent portion and the base substrate is less than the maximum distance between the additional bank and the base substrate, the supporting portion may not be provided.

In consideration of obtaining a thin panel, the transparent material between the encapsulation layer of the array substrate and the protection layer of the wavelength converting unit-containing substrate may have a thickness controlled at 15 µm or less.

Fig. 15 shows a schematic diagram of a display panel assembled from a wavelength converting unit-containing substrate of the present disclosure. Here, the transparent portion 18 has a convex lens surface, which is easily damaged in cell alignment. At this time, a supporter 34 is provided, which preferably comprises a light-absorbing material.

In an embodiment, the wavelength converting unit-containing substrate further comprises a transparent layer, which is separated into transparent portions by the additional banks, and a transparent filling portion is filled between the transparent portions and the array substrate, wherein the transparent filling portion has a refractive index less than that of the transparent portion. Small refractive index is advantageous for avoiding total reflection at the interface. Also, when the transparent portion has a convex lens morphology, it may function to converge the backlight. The transparent filling portion may be an air layer or a layer of another material with small refractive index.

In some embodiments, when the transparent portion has a convex lens morphology, in view of converging light with the convex lens, the air layer may be maintained between the transparent portion and the array substrate. Optionally, a first transparent filler may be filled between the transparent layer and the array substrate, wherein the transparent portion has a refractive index greater than that of the first transparent filler. Fig. 15 shows a transparent portion with a convex lens morphology. In Fig. 15, 16 represents the reflecting layer, 21 represents the air layer, 34 represents the supporter, and 173a, 173b and 173c represent the color filters respectively. Here, the first transparent filler 21 has a refractive index greater than that of the transparent portion 18. Details for conventional TFT and OLED are not particularly shown in the figure.

In some embodiments, the transparent portion may have a concave lens morphology, and a second transparent filler may be filled between the transparent layer and the array substrate, wherein the transparent portion has a refractive index less than that of the second transparent filler, which may also achieve the light converging effect. Fig. 17 shows a transparent layer with a concave lens morphology. Here, the second transparent filler 23 has a refractive index greater than that of the transparent portion 18. The reference numbers in Fig. 17 are the same as those in Fig. 15.

In some embodiments, the material for the transparent portion is the same as a third transparent filler, and they are in an integrated structure, which may be prepared by a single filling process after cell alignment, so as to simplifying the preparation process. Fig. 18 shows an embodiment where only one kind of filling material for the transparent portion is filled between the wavelength converting unit-containing substrate and the array substrate. In this case, the space between the additional banks 15 of the wavelength converting unit-containing substrate is not pre-filled with the transparent portion, but is filled with the uniform transparent material when cell alignment. The reference numbers in Fig. 18 are the same as those in Fig. 15. In Figs. 17 and Fig. 18, even though there is no supporter, it is also possible that the cell alignment does not influence the convex surface. Therefore, the supporter may be omitted, and only the filler is used for supporting in the display area.

In some embodiments, when a distance between the wavelength converting unit and the array substrate in a direction perpendicular to the primary surface is set as a first distance d1, and a distance between the furthest position of the additional bank away from the base substrate and a plane in which the light-incoming surface of the wavelength converting unit is located is set as a second distance d2, the ratio of the second distance d2 to the first distance d1 is greater than or equal to 0.5. The ratio of the second distance d2 to the first distance d1 greater than or equal to 0.5 defines that the additional bank has a sufficient height to block the light with a large angle from an adjacent light emitting unit, thereby mitigating or eliminating the light crosstalk, and improving the display effect of the display panel. In some embodiments, d2/d1 is in a range of [0.5, 1]. When d2/d1 = 1, the additional bank is in direct contact with the array substrate, resulting in the best effect of blocking the leaked light. In some embodiments, d2/d1 is in a range of [0.5, 1), and the additional bank may be not in direct contact with the array substrate, and does not serve for supporting. In some embodiments, d2/d1 is in a range of [0.6, 0.9]. In some embodiments, d2/d1 is in a range of [0.65, 0.85]. In some embodiments, d2/d1 is in a range of [0.7, 0.8].

In an embodiment, the light emitting unit is an OLED light emitting unit. As such, an OLED display panel of wavelength converting type may be formed. When the QD wavelength converting unit is used in combination, a QD-OLED display panel may be formed.

In an embodiment, the present disclosure also provides a method for manufacturing the wavelength converting unit-containing substrate, comprising steps of:
forming the bank layer and forming the auxiliary bank at a side of a portion of the bank segments in the bank layer away from the base substrate; and
after forming the auxiliary bank, forming the additional bank at a side of the auxiliary bank away from the base substrate.

As described above, this may provide good fixation for the additional bank.

In an embodiment, the step of forming the bank layer and forming the auxiliary bank comprises:
coating a photocurable material on the base substrate, and
forming the bank layer and forming the auxiliary bank integrally by exposure once with a halftone mask, such that an orthographic projection of a top surface of the auxiliary bank on the base substrate has a width less than that of an orthographic projection of a bottom surface of the auxiliary bank on the base substrate, and an orthographic projection of a top surface of the bank segment on the base substrate has a width greater than that of an orthographic projection of a bottom surface of the bank segment on the base substrate.

As described above, an integrated structure with both a normal trapezoid auxiliary bank and an inverse trapezoid bank is prepared by exposure once with a halftone mask plate. Preferably, the photocurable material used for the bank is a dark color material, as long as it may cause insufficient exposure at both flanks of the bottom. Preferably, it is a black material. Furthermore, the layer of the photocurable material preferably has a thickness of 2 µm or more, so as to form an undercut at the bottom.

In an embodiment, a plurality of sub-pixel regions for the same color are continuously arranged to form a group of sub-pixel regions, the auxiliary banks between the group of sub-pixel regions and adjacent sub-pixel regions for a different color form a continuous auxiliary bank, the continuous auxiliary bank forms two parallel banks at both flanks of the group of sub-pixel regions, and no auxiliary bank is provided within the group of sub-pixel regions, and
the method comprises coating a material for the wavelength converting unit or the transparent color filtering unit in the group of sub-pixel regions between the two parallel banks by slit coating.

As described above, the sub-pixel regions are filled by slit coating. As compared to ink jet printing and lithographic patterning, slit coating greatly reduces the cost, and requires lower accuracy. The slit coater is easy to clean, which also increase the production efficiency.

In an embodiment, the two parallel banks are two parallel linear banks, that is, a linear area to be slit coated is provided, which greatly reduces the requirements on the automatic control of the slit coater.

### Example 1 Preparation of a wavelength converting unit-containing substrate

First, a color filter layer was prepared according to conventional technical means in related art to form a base substrate. Black matrices were firstly formed. In a direction between adjacent sub-pixels for different colors, the black matrices themselves had a width of 20 µm, and the center-to-center distance between the black matrices was 40 µm. The black matrices had a thickness of 1.2 µm.

Red, green and blue color filters were filled between the black matrices, and all the color filters had a thickness of 1.2 µm and an opening width of 20 µm.

Then, a bank layer and an auxiliary bank with the shapes in Fig. 16 were formed from a black photocurable material on the black matrices. After photocuring, the bank layer had a height of 8 µm, and the auxiliary bank layer had a height of 3 µm. The bank layer had a bottom surface width of 15 µm, a top surface width of 25 µm, a height of 8 µm, and a width of an orthographic projection of the oblique edge on the base substrate of 5 µm. The bank between the sub-pixels for the same color also had the same section shape. The auxiliary bank had a bottom surface width of 10 µm, a top surface width of 6 µm, and a height of 3 µm.

Then, an Ag reflecting layer with a thickness of 3000 Å was obtained on the lateral surface of the bank layer by sputtering-dry etching.

Then, the sub-pixel regions were filled by respectively coating a red QD material, a green QD material, and a transparent color filtering material along the channels between the auxiliary banks by a slit coater with a nozzle having a width of 15 µm. Then, exposure and development were performed, and the material in the sub-pixel regions was remained.

Subsequently, a protection layer of SiNx with a thickness of 2500 Å was applied to protect the sub-pixel regions. Thereafter, an additional bank was formed by using a black photocurable material. The additional bank had a bottom width of 21 µm, a height of 10 µm, and a top width of 10 µm. After curing, a coating layer having lyophobic property to an acrylic resin was coated on the top of the additional bank.

The acrylic resin was filled into the region between the additional banks, which naturally forms a convex top surface. The organic transparent filler wad dried and cured.

Thus, a color filter substrate was prepared.

### Example 2 Preparation of a display panel

The array substrate as shown in Fig. 14 was provided according to the method in related art. A supporter with a height of 2 µm was additionally formed on the pixel defining layer of the array substrate. The position of the supporter corresponds to the position of the additional bank of the wavelength converting unit-containing substrate prepared in Example 1. The supporter was also prepared from a black light-absorbing material.

The wavelength converting unit-containing substrate prepared in Example 1 was cell aligned with the array substrate according to the manner as shown in Fig. 1(b), and no new filler was filled therebetween to maintain a thin air layer. Thus, a display panel was prepared. Fig. 15 schematically shows a structure of a display panel manufactured according to the present example.

In the display panel, light leakage substantially would not occur between the sub-pixels for different colors. The additional bank as the main barrier for cross color was firmly fixed on the top of the bank by the auxiliary bank. The inverse trapezoid bank cooperated with the reflecting layer on its lateral surface to increase the light output efficiency. The transparent layer functioned as a convex lens to converge the light emitted by the light emitting unit in the sub-pixel array substrate. Thereby, a display panel having excellent display performance was obtained.

The above descriptions are only particular embodiments of the present disclosure, but the protection scope of the present disclosure is not limited thereto. Within the technical scope disclosed in the present disclosure, one skilled in the art may readily envisage variations and alternatives, and all of them are covered by the protection scope of the present disclosure. Therefore, the protection scope of the present disclosure should be defined by the appended claims.

## Claims

1. A wavelength converting unit-containing substrate comprising:
a bank layer (12) disposed on a base substrate (17), the bank layer comprising a plurality of bank segments, which are interconnected to enclose a plurality of sub-pixel regions, wherein adjacent sub-pixel regions are spaced apart by one of the plurality of bank segments,
the plurality of sub-pixel regions comprises sub-pixel regions for different colors, and each of the sub-pixel regions is filled with a wavelength converting unit for a corresponding color or filled with a transparent color filtering unit,
wherein for a bank segment between adjacent sub-pixel regions for different colors, an additional bank (15) is provided at a side thereof away from the base substrate, **characterized in that**
for a bank segment between adjacent sub-pixel regions for the same color, no additional bank is provided at a side thereof away from the base substrate,
for the bank segment between the adjacent sub-pixel regions for different colors, an auxiliary bank (13) is further provided on the side thereof away from the base substrate, and is between the bank segment and the additional bank, wherein an orthographic projection of the auxiliary bank on the base substrate has a width less than that of an orthographic projection of the additional bank on the base substrate, and a maximum distance between the auxiliary bank and the base substrate is greater than a minimum distance between the additional bank and the base substrate, and **in that**
a plurality of sub-pixel regions for the same color are continuously arranged to form a group of sub-pixel regions, the auxiliary banks between the group of sub-pixel regions and sub-pixel regions adjacent thereto form a continuous auxiliary bank, and no auxiliary bank is provided within the group of sub-pixel regions, wherein the continuous auxiliary bank preferably forms two parallel banks at both flanks of the group of sub-pixel regions.

2. The wavelength converting unit-containing substrate according to claim 1,
wherein the auxiliary bank has a height in a range of 2 µm to 5 µm.

3. The wavelength converting unit-containing substrate according to claim 1, wherein the wavelength converting unit-containing substrate further comprises a protection layer, which is disposed at a side of the additional bank close to the base substrate and at a side of the auxiliary bank, the bank layer and the sub-pixel regions away from the base substrate.

4. The wavelength converting unit-containing substrate according to claim 1, wherein the auxiliary bank has a second cross section in a direction perpendicular to a primary surface of the base substrate, and when second transversal line segments in the second cross section are taken along a direction from being away from the base substrate to being close to the base substrate, there is a negative correlation between lengths of the second transversal line segments and distances from the second transversal line segments to the base substrate.

5. The wavelength converting unit-containing substrate according to claim 1, wherein a ratio of a width of an orthographic projection of a bottom surface of the auxiliary bank on the base substrate to a width of an orthographic projection of a top surface of the bank segment between the auxiliary bank and the base substrate on the base substrate is in a range of 30% to 50%.

6. The wavelength converting unit-containing substrate according to any one of claims 1 to 5, wherein the wavelength converting unit-containing substrate further comprises a transparent layer, wherein the transparent layer is separated into transparent portions by the additional banks, and at least a part of the transparent portions have a convex lens morphology, wherein a contact angle of an epoxy resin or an acrylic resin on a top surface of the additional bank is preferably greater than or equal to 90°.

7. The wavelength converting unit-containing substrate according to any one of claims 1 to 5, wherein a ratio of a width of an orthographic projection of a bottom surface of the additional bank on the base substrate to a width of an orthographic projection of a top surface of the bank segment between the additional bank and the base substrate on the base substrate is in a range of 0.8 to 0.9.

8. The wavelength converting unit-containing substrate according to any one of claims 1 to 5, wherein the additional bank comprises a black light-absorbing material, or a lateral surface of the additional bank comprises a light reflecting layer.

9. The wavelength converting unit-containing substrate according to any one of claims 1 to 5, wherein the additional bank has a first cross section in a direction perpendicular to a primary surface of the base substrate, and when first transversal line segments in the first cross section are taken along a direction being away from the base substrate to being close to the base substrate, there is a negative correlation between lengths of the first transversal line segments and distances from the first transversal line segments to the base substrate.

10. The wavelength converting unit-containing substrate according to any one of claims 1 to 5, wherein the base substrate comprises a color filter layer comprising a black matrix and color filters in spaces enclosed by the black matrix, wherein an orthographic projection of the bank segment on the base substrate is within an orthographic projection of the black matrix on the base substrate, and a ratio of a width of an orthographic projection of a bottom surface of the bank segment on the base substrate to a width of an orthographic projection of the black matrix on the base substrate is in a range of 0.8 to 0.9.

11. A display panel comprising:
an array substrate, wherein the array substrate comprises a pixel defining layer and light emitting units in spaces enclosed by the pixel defining layer, and
the wavelength converting unit-containing substrate according to any one of claims 1 to 10 aligned with the array substrate,
wherein the display panel comprises sub-pixels arranged in an array, wherein each of the sub-pixels comprises one light emitting unit in the array substrate and one wavelength converting unit or transparent color filtering unit in the wavelength converting unit-containing substrate, and the light emitting unit is disposed to be overlapped by the wavelength converting unit or transparent color filtering unit,
wherein a plurality of supporters are preferably further provided between the array substrate and the wavelength converting unit-containing substrate, and the supporters are in contact with at least a portion of the additional banks,
wherein the light emitting unit is preferably an OLED light emitting unit.

12. The display panel according to claim 11, wherein the wavelength converting unit-containing substrate further comprises a transparent layer, which is separated into transparent portions by the additional banks, and a transparent filling portion is filled between the transparent portions and the array substrate, wherein the transparent filling portion has a refractive index less than that of the transparent portion.

## Patentansprüche

1. Substrat mit Wellenlängenumwandlungseinheit, umfassend:
eine Bankschicht (12), die auf einem Basissubstrat (17) angeordnet ist, wobei die Bankschicht eine Vielzahl von Banksegmenten aufweist, die miteinander verbunden sind, um eine Vielzahl von Subpixelbereichen einzuschließen, wobei benachbarte Subpixelbereiche durch eines der Vielzahl von Banksegmenten mit Abstand voneinander angeordnet sind,
die Vielzahl von Subpixelbereichen Subpixelbereiche für unterschiedliche Farben aufweist und jeder der Subpixelbereiche mit einer Wellenlängenumwandlungseinheit für eine entsprechende Farbe befüllt ist oder mit einer transparenten Farbfiltereinheit befüllt ist,
wobei für ein Banksegment zwischen benachbarten Subpixelbereichen für unterschiedliche Farben eine zusätzliche Bank (15) an einer von dem Basissubstrat entfernten Seite desselben bereitgestellt ist, **dadurch gekennzeichnet, dass**
für ein Banksegment zwischen benachbarten Subpixelbereichen für dieselbe Farbe an einer von dem Basissubstrat entfernten Seite keine zusätzliche Bank bereitgestellt ist,
für das Banksegment zwischen den benachbarten Subpixelbereichen für unterschiedliche Farben zusätzlich eine Hilfsbank (13) an der von dem Basissubstrat entfernten Seite bereitgestellt ist und sich zwischen dem Banksegment und der zusätzlichen Bank befindet, wobei eine orthographische Projektion der Hilfsbank auf dem Basissubstrat eine Breite hat, die kleiner ist als diejenige einer orthographischen Projektion der zusätzlichen Bank auf dem Basissubstrat und ein maximaler Abstand zwischen der Hilfsbank und dem Basissubstrat größer ist als ein minimaler Abstand zwischen der zusätzlichen Bank und dem Basissubstrat, und dadurch, dass
eine Vielzahl von Subpixelbereichen für dieselbe Farbe durchgehend angeordnet ist, um eine Gruppe von Subpixelbereichen zu bilden, die Hilfsbänke zwischen der Gruppe von Subpixelbereichen und ihnen benachbarten Subpixelbereichen eine durchgehende Hilfsbank bilden und innerhalb der Gruppe von Subpixelbereichen keine Hilfsbank bereitgestellt ist, wobei die durchgehende Hilfsbank vorzugsweise zwei parallele Bänke an beiden Flanken der Gruppe von Subpixelbereichen bildet.

2. Substrat mit Wellenlängenumwandlungseinheit nach Anspruch 1,
wobei die Hilfsbank eine Höhe in einem Bereich von 2 µm bis 5 µm hat.

3. Substrat mit Wellenlängenumwandlungseinheit nach Anspruch 1, wobei das Substrat mit Wellenlängenumwandlungseinheit ferner eine Schutzschicht aufweist, die an einer Seite der zusätzlichen Bank nahe dem Basissubstrat und an einer von dem Basissubstrat, der Hilfsbank, der Bankschicht und den Subpixelbereichen entfernten Seite angeordnet ist.

4. Substrat mit Wellenlängenumwandlungseinheit nach Anspruch 1, wobei die Hilfsbank in einer Richtung senkrecht zu einer primären Fläche des Basissubstrats einen zweiten Querschnitt hat, und wenn zweite transversale Liniensegmente in dem zweiten Querschnitt entlang einer Richtung von einer von dem Basissubstrat entfernten Position zu einer dem Basissubstrat nahen Position betrachtet werden, zwischen Längen der zweiten transversalen Liniensegmente und Abständen der zweiten transversalen Liniensegmente zu dem Basissubstrat eine negative Korrelation besteht.

5. Substrat mit Wellenlängenumwandlungseinheit nach Anspruch 1, wobei ein Verhältnis einer Breite einer orthographischen Projektion einer Unterseite der Hilfsbank auf dem Basissubstrat zu einer Breite einer orthographischen Projektion einer Oberseite des Banksegments zwischen der Hilfsbank und dem Basissubstrat auf dem Basissubstrat in einem Bereich von 30 % bis 50 % liegt.

6. Substrat mit Wellenlängenumwandlungseinheit nach einem der Ansprüche 1 bis 5, wobei das Substrat mit Wellenlängenumwandlungseinheit ferner eine transparente Schicht aufweist, wobei die transparente Schicht durch die zusätzlichen Bänke in transparente Abschnitte unterteilt ist und mindestens ein Teil der transparenten Abschnitte eine konvexe Linsenmorphologie aufweist, wobei ein Kontaktwinkel eines Epoxidharzes oder eines Acrylharzes auf einer Oberseite der zusätzlichen Bank vorzugsweise größer oder gleich 90° ist.

7. Substrat mit Wellenlängenumwandlungseinheit nach einem der Ansprüche 1 bis 5, wobei ein Verhältnis einer Breite einer orthographischen Projektion einer Unterseite der zusätzlichen Bank auf dem Basissubstrat zu einer Breite einer orthographischen Projektion einer Oberseite des Banksegments zwischen der zusätzlichen Bank und dem Basissubstrat auf dem Basissubstrat in einem Bereich von 0,8 bis 0,9 liegt.

8. Substrat mit Wellenlängenumwandlungseinheit nach einem der Ansprüche 1 bis 5, wobei die zusätzliche Bank ein schwarzes, lichtabsorbierendes Material aufweist oder eine Seitenfläche der zusätzlichen Bank eine lichtreflektierende Schicht aufweist.

9. Substrat mit Wellenlängenumwandlungseinheit nach einem der Ansprüche 1 bis 5, wobei die zusätzliche Bank in einer Richtung senkrecht zu einer primären Fläche des Basissubstrats einen ersten Querschnitt hat, und wenn erste transversale Liniensegmente in dem ersten Querschnitt entlang einer Richtung von einer von dem Basissubstrat entfernten Position zu einer dem Basissubstrat nahen Position betrachtet werden, zwischen Längen der ersten transversalen Liniensegmente und Abständen der ersten transversalen Liniensegmente zu dem Basissubstrat eine negative Korrelation besteht.

10. Substrat mit Wellenlängenumwandlungseinheit nach einem der Ansprüche 1 bis 5, wobei das Basissubstrat eine Farbfilterschicht aufweist, die eine schwarze Matrix und in von der schwarzen Matrix umschlossenen Räumen Farbfilter aufweist, wobei eine orthographische Projektion des Banksegments auf dem Basissubstrat innerhalb einer orthographischen Projektion der schwarzen Matrix auf dem Basissubstrat liegt und ein Verhältnis der Breite einer orthographischen Projektion einer Unterseite des Banksegments auf dem Basissubstrat zu einer Breite einer orthographischen Projektion der schwarzen Matrix auf dem Basissubstrat in einem Bereich von 0,8 bis 0,9 liegt.

11. Anzeigetafel, umfassend:
ein Arraysubstrat, wobei das Arraysubstrat eine pixeldefinierende Schicht und in von der pixeldefinierenden Schicht umschlossenen Räumen Lichtemissionseinheiten aufweist, und
das Substrat mit Wellenlängenumwandlungseinheit nach einem der Ansprüche 1 bis 10, das mit dem Arraysubstrat ausgerichtet ist,
wobei die Anzeigetafel Subpixel aufweist, die in einem Array angeordnet sind, wobei jedes der Subpixel eine Lichtemissionseinheit in dem Arraysubstrat und eine Wellenlängenumwandlungseinheit oder transparente Farbfiltereinheit in dem Substrat mit Wellenlängenumwandlungseinheit aufweist und die Lichtemissionseinheit so angeordnet ist, dass sie von der Wellenlängenumwandlungseinheit oder transparenten Farbfiltereinheit überlappt wird,
wobei vorzugsweise ferner eine Vielzahl von Stützen zwischen dem Arraysubstrat und dem Substrat mit Wellenlängenumwandlungseinheit bereitgestellt ist und die Stützen mit mindestens einem Abschnitt der zusätzlichen Bänke in Kontakt stehen,
wobei die Lichtemissionseinheit vorzugsweise eine OLED-Lichtemissionseinheit ist.

12. Anzeigetafel nach Anspruch 11, wobei das Substrat mit Wellenlängenumwandlungseinheit ferner eine transparente Schicht aufweist, die durch die zusätzlichen Bänke in transparente Abschnitte unterteilt ist, und ein transparenter Füllabschnitt zwischen den transparenten Abschnitten und dem Arraysubstrat befüllt ist, wobei der transparente Füllabschnitt einen Brechungsindex aufweist, der kleiner ist als derjenige des transparenten Abschnitts.

## Revendications

1. Substrat comprenant une unité de conversion de longueur d'onde comprenant :
une couche de banc (12) disposée sur un substrat de base (17), la couche de banc comprenant une pluralité de segments de banc qui sont interconnectés pour enchâsser une pluralité de régions de sous-pixels, dans lequel des régions de sous-pixels adjacentes sont espacées par un de la pluralité des segments de banque,
la pluralité de régions de sous-pixels comprend des régions de sous-pixels pour différentes couleurs, et chacune des régions de sous-pixels est remplie d'une unité de conversion de longueur d'onde pour une couleur correspondante ou remplie avec une unité de filtrage de couleur transparente,
dans lequel pour un segment de banque entre des régions de sous-pixels adjacentes pour différentes couleurs, une banque supplémentaire (15) est prévue sur un côté de celui-ci à distance du substrat de base, **caractérisé en ce que**
pour un segment de banque entre des régions de sous-pixels pour la même couleur, aucune banque supplémentaire n'est prévue sur un côté de celui-ci à distance du substrat de base,
pour le segment de banque entre les régions de sous-pixels adjacentes pour différentes couleurs, une banque auxiliaire (13) est en outre prévue sur le côté de celui-ci à distance du substrat de base, et est entre le segment de banque et la banque auxiliaire, dans lequel une projection orthographique de la banque auxiliaire sur le substrat de base présente une largeur inférieure à celle d'une projection orthographique de la banque supplémentaire sur le substrat de base, et une distance maximale entre la banque auxiliaire et le substrat de base est supérieure à une distance minimale entre la banque supplémentaire et le substrat de base, et **en ce qu'**une pluralité de régions de sous-pixels pour la même couleur sont agencées en continu pour former un groupe de régions de sous-pixels, les banques auxiliaires entre le groupe de régions de sous-pixels et les régions de sous-pixels adjacentes à celui-ci forment une banque auxiliaire continue, et aucune banque auxiliaire n'est prévue à l'intérieur du groupe de régions de sous-pixels, dans lequel la banque auxiliaire continue forme de préférence deux banques parallèles sur les deux flancs du groupe de régions de sous-pixels.

2. Substrat comprenant une unité de conversion de longueur d'onde selon la revendication 1, dans lequel la banque auxiliaire présente une hauteur dans une plage de 2 µm à 5 µm.

3. Substrat comprenant une unité de conversion de longueur d'onde selon la revendication 1, dans lequel le substrat comprenant une unité de conversion de longueur d'onde comprend en outre une couche de protection qui est disposée sur un côté de la banque supplémentaire à proximité du substrat de base et sur un côté de la banque auxiliaire, la couche de banque et les régions de sous-pixels à distance du substrat de base.

4. Substrat comprenant une unité de conversion de longueur d'onde selon la revendication 1, dans lequel la banque auxiliaire présente une seconde section transversale dans une direction perpendiculaire à une surface principale du substrat de base, et lorsque des seconds segments de ligne transversaux dans la seconde section transversale sont pris le long d'une direction allant d'éloignée du substrat de base à proche du substrat de base, il y a une corrélation négative entre des longueurs des seconds segments de ligne transversaux et des distances des seconds segments de ligne transversaux au substrat de base.

5. Substrat comprenant une unité de conversion de longueur d'onde selon la revendication 1, dans lequel un rapport d'une largeur d'une projection orthographique d'une surface de dessous de la banque auxiliaire sur le substrat de base à une largeur d'une projection orthographique d'une surface de dessus du segment de banque entre la banque auxiliaire et le substrat de base sur le substrat de base est dans une plage de 30 % à 50 %.

6. Substrat comprenant une unité de conversion de longueur d'onde selon l'une quelconque des revendications 1 à 5, dans lequel le substrat comprenant une unité de conversion de longueur d'onde comprend en outre une couche transparente, dans lequel la couche transparente est séparée en des parties transparentes par les banques supplémentaires, et au moins une partie des parties transparentes présente une morphologie de lentille convexe, dans lequel un angle de contact d'une résine époxy ou d'une résine acrylique sur une surface de dessus de la banque supplémentaire est de préférence supérieure ou égal à 90°.

7. Substrat comprenant une unité de conversion de longueur d'onde selon l'une quelconque des revendications 1 à 5, dans lequel un rapport d'une largeur d'une projection orthographique d'une surface de dessous de la banque supplémentaire sur le substrat de base à une largeur d'une projection orthographique d'une surface de dessus du segment de banque entre la banque supplémentaire et le substrat de base sur le substrat de base est situé dans la plage de 0,8 à 0,9.

8. Substrat comprenant une unité de conversion de longueur d'onde selon l'une quelconque des revendications 1 à 5, dans lequel la banque supplémentaire comprend un matériau noir absorbant la lumière, ou une surface latérale de la banque supplémentaire comprend une couche réfléchissant la lumière.

9. Substrat comprenant une unité de conversion de longueur d'onde selon l'une quelconque des revendications 1 à 5, dans lequel la banque supplémentaire présente une première section transversale dans une direction perpendiculaire à une surface principale du substrat de base, et lorsque les premiers segments de ligne transversaux dans la première section transversale sont pris le long d'une direction allant d'éloignée du substrat de base à proche du substrat de base, il y a une corrélation négative entre des longueurs des premiers segments de ligne transversaux et des distances des premiers segments de ligne transversaux au substrat de base.

10. Substrat comprenant une unité de conversion de longueur d'onde selon l'une quelconque des revendications 1 à 5, dans lequel le substrat de base comprend une couche de filtre de couleur comprenant une matrice noire et des filtres de couleurs dans des espaces enchâssés par la matrice noire, dans lequel une projection orthographique du segment de banque sur le substrat de base est comprise dans une projection orthographique de la matrice noire sur le substrat de base, et un rapport d'une largeur d'une projection orthographique d'une surface de dessous du segment de banque sur le substrat de base à une largeur d'une projection orthographique de la matrice noire sur le substrat de base est situé dans une plage de 0,8 à 0,9.

11. Panneau d'affichage comprenant :
un substrat de réseau, dans lequel le substrat de réseau comprend une couche de définition de pixels et des unités d'émission de lumière dans des espaces enchâssés par la couche de définition de pixels, et
le substrat comprenant une unité de conversion de longueur d'onde selon l'une quelconque des revendications 1 à 10 aligné avec le substrat de réseau,
dans lequel le panneau d'affichage comprend des sous-pixels agencés dans un réseau, dans lequel chacun des sous-pixels comprend une unité d'émission de lumière dans le substrat de réseau et une unité de conversion de longueur d'onde ou unité de filtrage de couleur transparente dans le substrat comprenant une unité de conversion de longueur d'onde, et l'unité d'émission de lumière est disposée pour être recouverte par l'unité de conversion de longueur d'onde ou l'unité de filtrage de couleur transparente,
dans lequel une pluralité de supports sont de préférence fournis en outre entre le substrat de réseau et le substrat comprenant une unité de conversion de longueur d'onde, et les supports sont en contact avec au moins une partie des banques supplémentaires,
dans lequel l'unité d'émission de lumière est de préférence une unité d'émission de lumière à diodes électroluminescentes organiques.

12. Panneau d'affichage selon la revendication 11, dans lequel le substrat comprenant une unité de conversion de longueur d'onde comprend en outre une couche transparente, qui est séparée en des parties transparentes par les banques supplémentaires, et une partie de remplissage transparente est remplie entre les parties transparentes et le substrat de réseau, dans lequel la partie de remplissage transparente présente un indice de réfraction inférieur à celui de la partie transparente.
